# EUROPEAN PATENT APPLICATION

(11) **EP 2 529 931 A1**
(43) Date of publication of application: **05.12.2012**
(21) Application number: 11737147.6
(22) Date of filing: 28.01.2011
(51) Int. Cl.: B41F 15/36, B41F 15/08, H05K 3/34

(54) **SCREEN STRETCH FRAME**

(30) Priority: 29.01.2010 JP 2010018704; 29.01.2010 JP 2010018703
(71) Applicant: Kasuya, Furetsu, Kodaira-shi Tokyo 187-0025 (JP)
(72) Inventor: Kasuya, Furetsu, Kodaira-shi Tokyo 187-0025 (JP)
(74) Representative: Farrington, Graham
(86) International application number: PCT/JP2011/051722
(87) International publication number: WO 2011/093437

(57) **Abstract**

A screen extending frame in which a screen attached thereto is not distorted even when a screen extending jig is removed therefrom for storage or transportation is provided.

Cut grooves are formed from the inner side to the outer side of, or from the outer side to the inner side of the direction, or in both directions of couplings of the screen extending frame constituted by connecting four frame members in a rectangle shape by means of welding, or the like, and the cut grooves enable the couplings to deform.

The four frame members constituting the screen extending frame, which are individual bodies, join by corner members, and connecting portions are inclined with respect to the longitudinal direction of the frame members, thereby gaps are created in the connections. Alternatively, elastic elements are placed at the connections of the four frame members constituting the screen extending frame.

Alternatively, the connecting portions are orthogonal to the longitudinal direction, and elastic elements are placed at the connections.

## Description

### Technical Field

The present invention relates to a screen extending frame in which a screen for screen printing in a sheet shape or a mesh shape is extended and is mounted on a screen extending jig for adjusting tension of the screen in regard to manufacturing of printed circuit boards.

### Background Art

A printed circuit board in the subtractive process that is generally used in electric/electronic devices is configured to be formed with a conductive pattern by removing unnecessary portions of copper foil stuck to an insulating substrate, and active and passive elements are fixed to the conductive pattern by means of soldering, or the like.

In the subtractive process, after holes are made on an insulating substrate, such as a glass epoxy plate, to which copper foil is stuck, unnecessary portions of the copper foil is removed by printing and etching, and then a conductive pattern is formed. When soldering is performed by a reflow method, solder cream is printed further on necessary portions.

In screen printing, a screen board, which is a mesh-like sheet woven with a metal or a resin or a sheet made of a metal or a resin, is used by forming holes of image thereon and by extending the sheet in a frame with uniform tension, not making crinkles.

With regard to a printed pattern, a metal mask where through holes are formed on a metal thin plate made of stainless steel or the like is extended in a screen extending frame with tension, ink is transferred onto the insulating substrate via the through holes using a squeegee, and thereby, a conductive pattern or a solder pattern is formed thereon.

At this moment, if the screen board does not come into tight contact with the object to be printed, the ink runs over from a gap causing bleeding, which results in inaccurate printing.

A planar shape is ideal for the object to be printed, but there may be warping or waviness thereon in some cases, and a material with flexibility is selected for the squeegee in order to keep the screen board in tight contact with the printed object, and the extending tension of the screen is not so tensed.

However, since the screen is required to be as strongly extended as possible, a rigid and sturdy screen frame is prepared, the sheet is intensively pulled from four directions, and extended using a stretching property of the sheet material and using a repulsive force thereof.

When a metal mesh is used, it can be extended since the mesh does not have a high stretching property but has a little. When a metal sheet with no stretching property is used, the sheet can be extended by connecting the outer circumference of the centered metal sheet to a resin sheet having the stretching property.

The screen is used as attached to the screen extending frame. If there has slack, the location of the printed pattern is deviated or the pattern is warped when the screen is rubbed by the squeegee. In order to prevent such a situation, it is necessary to always give a certain degree of tension to the screen by exerting a tensile force thereto when printing is performed.

For a screen extending frame, there are a tension fixed frame of which the size is fixed so as to maintain the tensile force of the screen constant, and a tension variable frame of which the size varies so as to be able to change the tensile force of the screen. Since both frames are required to have strength that gives a tensile force to the screen, the frames have to be robust and large. In addition, the tension variable frame of which the size varies includes a variable mechanism, and accordingly, the frame costs higher.

The screen needs to be separated from the circuit board to be printed before and after printing, and to be brought into tight contact with the circuit board when printing is performed using a squeegee. For this reason, the screen is required to have the stretching property. However, since the metal mask does not have the stretching property, it is, in general, stuck to a mesh made of polyester strings, stainless steel strings, or the like and is used as a screen. There may be a case where a metal mask is used as it is, and in that case, any extending and reducing mechanism is provided in the mounting portion of the metal mask or in the screen extending frame.

A screen using a mesh is attached to the screen extending frame mostly by using an adhesive agent, and such the screen is kept attached to the screen extending frame so long as the screen is necessary. For this reason, when being not in use, the heavy and bulky screen has to be stored or transported.

There is a screen extending frame in a configuration where the end part of the screen using a mesh is attached thereto by means of winding, clamping, or the like. In a case of such the screen extending frame, it is possible to remove the screen from the screen extending frame for storage or transportation when the screen is not in use, but it is not easy to store or transport the screen without damaging the printing patterns that are precisely formed thereon as the screen is thin.

Taking the circumstances into consideration, the present inventor has proposed in Patent Application No. 2002-556010 (refer to Publication No. WO2002/055304) a device for screen printing in which a screen extending frame is divided into a screen extending jig having a tensile force adjusting mechanism and a screen extending frame in a simple structure without the tensile force adjusting mechanism, which is provided with an engagement mechanism to connect the jig and the frame with each other, and thereby, the screen is attached to the screen extending frame.

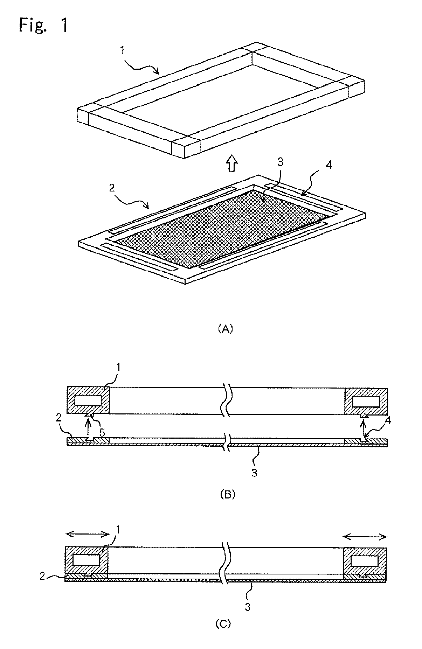

The screen printing device is described referring to Fig. 1.
In Fig. 1 (A), the reference numeral 1 is the screen extending jig, and the screen extending frame 2 having engagement grooves 4 is mounted on the screen extending jig 1. To the screen extending frame 2, a screen 3 is attached, which is a sheet that is a metal plate or a resin plate with conductive patterns formed by through holes, or is a mesh stuck a sheet with conductive patterns formed by through holes, not shown in the drawing, thereto. By extending and reducing the screen extending jig 1, an appropriate tensile force is exerted on the screen 3.
The screen extending frame 2 is constituted by joining four plate-shaped, or rectangular tube-shaped frame members together by means of welding, or the like.

In description hereinafter, on frame members constituting the screen extending frame, the length in the longitudinal direction of each frame member represents the "length", the length from the outside to the inside thereof represents the "width", and the length between a face to which the sheet is attached and a face to which the sheet is not attached represents the "thickness".

Figs. 1 (B) and (C) illustrate mounting the screen extending frame 2 on the screen extending jig 1. Fig. 1 (B) shows the state of the screen extending frame 2 before being mounted on the screen extending jig 1, and Fig. 1 (C) shows the state of the screen extending frame 2 being mounted on the screen extending jig 1.

The engagement grooves 4 are formed on the mounting sides of the screen extending frame 2 along the longitudinal direction of the screen extending jig, and engagement elements 5 are formed on the mounting sides of the screen extending jig 1 along the longitudinal direction of the screen extending jig.

The tensile force to the screen 3 is adjusted by extending or reducing the screen extending jig 1 in the arrow directions shown in the drawing where the engagement elements 5 are kept engaged with the engagement grooves 4.
Conductive patterns are formed using the screen by transferring ink with a squeegee not shown in the drawing via through holes.

When the screen is not in use and to be stored, it is most ideal to store the screen extending frame 2 being mounted on the screen extending jig 1, but since the screen extending jig 1 having an extending and reducing mechanism is not only expensive but also bulky, storage or transportation of the screen extending frame 2 attached with the screen being mounted on the screen extending jig 1 is not efficient.

The screen is attached to the screen extending frame 2 by fixing means such as an adhesive agent, that is mounted on the screen extending jig 1, and the tensile force is exerted thereon by the screen extending jig 1. When not being mounted on the screen extending jig 1, slack or the like occurs which may cause the screen deformation. It is, therefore, desirable for the screen to have a certain degree of tension even being attached only to the screen extending frame 2.

A screen printing device using a screen extending frame, in which the screen is attached to a screen extending frame, the screen extending frame is mounted on the screen extending jig, and the tension of the screen is adjusted by changing the size of the screen extending jig, is disclosed in Japanese Patent Laid-Open Publication Nos. 2006-212955, 2006-44180 and 2008-1010 by the present inventor, in addition to the publication WO2002/055304. Furthermore, Japanese Patent Laid-Open Publication No. 2000-15777 also describes a screen printing device using a screen extending frame.

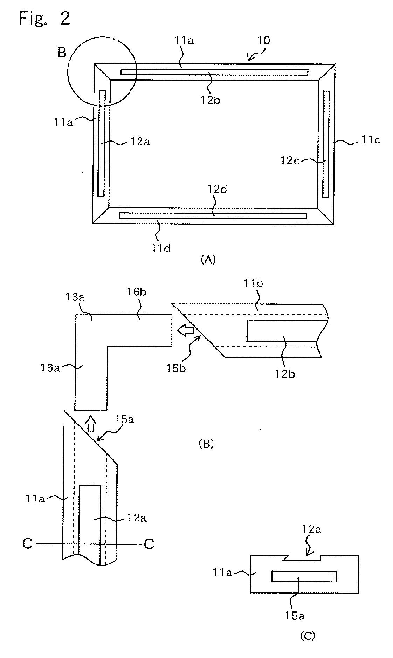

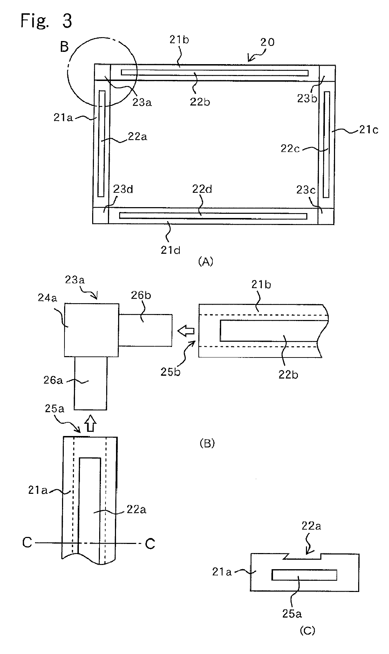

Figs. 2 and 3 show the configuration of the screen extending frame of the related art shown in Japanese Patent Laid-Open Publication Nos. 2006-212955 and 2008-1010.
In the drawings, (A) is an overall view of the screen extending frame, (B) is an enlarged exploded view of a portion indicated by a dashed circle B in (A), and (C) is a cross-sectional view of a portion indicated by a dashed line C in (B).

The screen extending frame 10 shown in Fig. 2 is constituted by two parallel frame members 11a and 11c, two frame members 11b and 11d that are arranged orthogonal to the above frame members and parallel to each other, and four corner members 13a, 13b, 13c, and 13d that connect the above four frame members.

On the four frame members 11a, 11b, 11c, and 11d, engagement grooves 12a, 12b, 12c, and 12d are formed, with which engagement elements formed on a screen extending jig are engaged.

The four frame members 11a, 11b, 11c, and 11d have the same cross-sectional shape, and the frame member 11a shown in Fig. 2 (B) as a representative example has an insertion hole 15a inside thereof and the engagement groove 12a formed on one face to be engaged with the engagement element of the screen extending jig, and has a flat face on the other side so as to attach a screen thereto. In addition, both ends of four frame members 11a, 11b, 11c, and 11d have planes at an angle of 90? with respect to the length direction.

The four corner members 13a, 13b, 13c, and 13d have the same cross-sectional shape, the corner member 13a shown in Fig. 2 (B) as a representative example is provided with two corner plates 17a and 17b orthogonal to cach other in a main body 14a of which the upper face is a square. The corner plates 17a and 17b have a cross-sectional shape so that the corner plates can be respectively inserted and slid in the insertion hole 16a of the frame member 11a and the insertion hole 16b of the frame member 11b.

The corner plate 16a is inserted into the insertion hole 15a of the frame member 11a in the arrow direction, the corner plate 16b is inserted into the insertion hole 15b of the frame member 11b in the arrow direction, and accordingly, the four frame members 11a, 11b, 11c, and 11d and the four corner members 13a, 13b, 13c, and 13d are assembled together to form the screen extending frame 10.

The screen is attached to the screen extending frame 10, the engagement elements of the extending jig are engaged with the engagement grooves 12a, 12b, 12c, and 12d, the corner plates inserted into the insertion holes slide in the insertion holes when the extending jig extends or reduces, whereby the screen extending frame 10 extends and reduces, and the tensile force is exerted on the screen.

A screen extending frame 20 shown in Fig. 3 is constituted by two parallel frame members 21a and 21c, two more frame members 21b and 21d that are arranged orthogonal to the above frame members and parallel to each other, and four corner members 23a, 23b, 23c, and 23d that connect the four frame members, not shown specifically in the drawing.

On the four frame members 21a, 21b, 21c, and 21d, engagement grooves 22a, 22b, 22c, and 22d are formed, with which engagement elements formed on a screen extending jig are engaged.

The four frame members 21a, 21b, 21c, and 21d have the same cross-sectional shape, and the frame member 21a shown in Fig. 3 (B) as a representative example has a insertion hole 25a inside thereof and the engagement groove 22a formed on one face to be engaged with the engagement element of the screen extending jig, and has a flat face on the other side so as to attach a screen thereto.
In addition, both ends of four frame members 21a, 21b, 21c, and 21d have inclined planes at the angle of 45? in this example, which incline to the inner side of the screen extending frame 20 in the length direction.

The four corner members 23a, 23b, 23c, and 23d have the same shape. The corner member 23a shown in Fig. 3 (B) as a representative example is provided with two corner plates 26a and 26b which are orthogonal to each other, have a cross-sectional shape so that the corner plates can be inserted and slid in the insertion holes 25a and 25b respectively.

The corner plate 26a is inserted into the insertion hole 25a of the frame member 21a in the arrow direction, the corner plate 26b is inserted into the insertion hole 25b in the arrow direction, and accordingly, the four frame members 21a, 21b, 21c, and 21d and the four corner members 22a, 22b, 22c, and 22d are assembled together to form the screen extending frame 20.

The screen is attached to the screen extending frame 20, the engagement elements of the screen extending jig are engaged with the engagement grooves 22a, 22b, 22c, and 22d, and the corner plates inserted into the insertion holes slide in the insertion holes when the screen extending jig extends or reduces, whereby the screen extending frame 20 extends or reduces, and the tensile force is exerted on the screen.

### Related Art References

- Document 1:: JP-A-2000-15777
- Document 2:: WO2002/055304
- Document 3:: JP-A-2006-212955
- Document 4:: JP-A-2006-44180
- Document 5:: JP-A-2008-1010

### Disclosure of the Invention

### Object of The Invention

These screen extending frames of the prior art can exert a certain degree of tension on the screen by exerting the tensile force to the screen when the screen is fixed thereto, but since the frame has no function of exerting the tensile force, it is not possible to exert a sufficient tension. For this reason, if the screen extending frame is removed from the bulky screen extending jig in order to effectively use the expensive screen extending frame to save space for storage and transportation, there is a concern that slack occurs in the screen, resulting in deformation of the screen.
The invention according to the present application aims to provide a screen extending frame that can prevent the above circumstance.

### Means

The configuration overview of the invention for achieving the above aim is as follows.
According to the invention provided in the present application, cut grooves are formed in the inner sides and/or outer sides of connections orthogonally connecting four frame members constituting a screen extending frame so that the angles of the connections change, allowing the frame members inwardly or outwardly change in shape, and accordingly, the size of the screen extending frame variable.

The screen extending frame mounted with an elastic element is reduced by a jig such as a screen extending jig having an extending and reducing function, a screen is attached to the screen extending frame in that state, and when fixing work, such as adhesion, is completed, setting the extending or reducing degree of the screen extending jig to be optimum, then screen printing is performed.

It is possible to extend and reduce the screen extending frame with an extending function by setting the function of extending the screen extending frame in a screen printing device.

In addition, in order to achieve the object of the invention, a gap or an elastic element is provided in each coupling of the four frame members so as to give an extending force to an end of a frame side in each connections of the frame members, whereby flexibility is given to the extending frame, according to the invention of the present application.

For the elastic element to be provided, a solid elastic element such as natural rubber or synthetic rubber, or a non-solid spring such as a plate spring or a coil spring can be used, and it is also possible to further provide an elastic element in the gap in the coupling.

The screen extending frame mounted with the elastic element is reduced by a jig such as a screen extending jig having an extending and reducing function, a screen is attached to the screen extending frame in that state, and when fixing work, such as adhesion, is completed, setting the extending or reducing degree of the screen extending jig to be optimum, then screen printing is performed.

It is possible to reduce the screen extending frame with a reducing function by setting the function of reducing the screen extending frame in a screen printing device.

Specific configurations for achieving the above objective are described in the following (1) to (38).

(1) A screen extending frame in a rectangular shape which is constituted by four frame members having the square-shape cross-section, and is used in such a way that a screen is attached to one face thereof, and the other face thereof is mounted on a screen extending jig having an extending and reducing function, in which couplings of the four frame members have flexibility and elasticity.

(2) The screen extending frame according to (1) above, in which the four frame members connect in the couplings, and the couplings have flexibility and elasticity.

(3) The screen extending frame according to (2) above, in which the four frame members are solid bodies.

(4) The screen extending frame according to (3) above, in which cut grooves are formed in the width direction of the couplings.

(5) The screen extending frame according to (3) above, in which cut grooves are formed in the direction connecting the outer angle and the inner angle each of the couplings.

(6) The screen extending frame according to (3) above, in which grooves are formed on both faces of the couplings in the thickness direction.

(7) The screen extending frame according to (6) above, in which the grooves in the thickness direction are formed in the width direction of the frame members.

(8) The screen extending frame according to (6) above, in which the grooves in the thickness direction are formed in the direction connecting the outer angle and the inner angle each of the couplings.

(9) The screen extending frame according to (3) above, in which through holes are formed in the thickness direction of the couplings.

(10) The screen extending frame according to (9) above, in which the through holes are disposed in the direction connecting the outer angle and the inner angle each of the couplings.

(11) The screen extending frame according to (9) above, in which the through holes are disposed in the width direction of the frame members.

(12) The screen extending frame according to (1) above, in which the four frame members are hollow bodies.

(13) The screen extending frame according to (12) above, in which notch portions are formed in the thickness direction of the couplings.

(14) The screen extending frame according to (13) above, in which the notch portions are formed in the direction orthogonal to the longitudinal direction of the frame members.

(15) The screen extending frame according to (13) above, in which the notch portions are formed in the direction connecting the outer angle and the inner angle each of the couplings.

(16) The screen extending frame according to (12) above, in which the notch portions are formed in the width direction of the frame members.

(17) The screen extending frame according to (16) above, in which the notch portions are formed in the direction connecting the outer angle and the inner angle each of the couplings.

(18) The screen extending frame according to (12) above, in which through holes are formed in the couplings toward the thickness direction of the frame members.

(19) The screen extending frame according to (18) above, in which the through holes are disposed in the direction connecting the outer angle and the inner angle each of the couplings.

(20) The screen extending frame according to (18) above, in which the through holes are disposed in the direction orthogonal to the longitudinal direction of the frame members.

(21) The screen extending frame according to (18) above, in which the through holes are disposed in the width direction of the frame members.

(22) The screen extending frame according to (1) above, in which the four frame members are two-tier hollow bodies including a hollow body having a plane onto which the screen is attached and a hollow body having a plane onto which the screen is not attached.

(23) The screen extending frame according to (22) above, in which notch portions are formed in the thickness direction of the coupling of the hollow-body having the plane onto which the screen is attached.

(24) The screen extending frame according to (23) above, in which the notch portions are formed in the width direction of the couplings.

(25) The screen extending frame according to (22) above, in which notch portions are formed on a wall face in the thickness direction of the frame side of the upper half hollow body in the two-tier hollow body.

(26) The screen extending frame according to (22) above, in which through holes are formed on the wall face in the thickness direction of the frame side of the upper half hollow body in the two-tier hollow body.

(27) The screen extending frame according to (1) above, in which the four frame members are individual units, adjacent frame members are joined by a corner member, and connections of the four frame members and the four corner members have flexibility and elasticity.

(28) The screen extending frame according to (27) above, in which end faces of connecting portions to which the four frame members are adjacent are faces inclined in the longitudinal direction of the four frame members, and gaps are formed between respective inclined faces.

(29) The screen extending frame according to (27) above, in which end faces of connecting portions to which the four frame members are adjacent are faces inclined in the longitudinal direction of the four frame members, and elastic elements are inserted between respective inclined faces.

(30) The screen extending frame according to (29) above, in which the elastic element is made of natural rubber or synthetic rubber.

(31) The screen extending frame according to (29) above, in which the elastic element is a coil spring.

(32) The screen extending frame according to (29) above, in which the elastic element is a leaf spring.

(33) The screen extending frame according to (27) above, in which end faces of connecting portions to which the four frame members are adjacent are faces orthogonal to the longitudinal direction of the four frame members, the corner members are rectangular parallelepiped shape, and elastic elements are inserted between the orthogonal faces of the frame members and the corner members.

(34) The screen extending frame according to (33) above, in which the elastic element is made of natural rubber or synthetic rubber.

(35) The screen extending frame according to (33) above, in which the elastic element is a coil spring.

(36) The screen extending frame according to (33) above, in which the clastic clement is a leaf spring.

(37) A screen printing apparatus, including a mechanism for mounting a screen extending frame, and a mechanism for extending and reducing the mounted screen extending frame.

### Brief Description of the Drawings

Fig. 1 illustrates a screen extending jig and a screen extending frame of the related art.
Fig. 2 illustrates a configuration of the screen extending frame of the related art.
Fig. 3 illustrates another configuration of the screen extending frame of the related art.
Fig. 4 is an illustrative configuration diagram of a screen extending frame according to Embodiment 1.
Fig. 5 is an illustrative function diagram of the screen extending frame according to Embodiment 1.
Fig. 6 is an illustrative configuration diagram of a screen extending frame according to Embodiment 2.
Fig. 7 is an illustrative function diagram of the screen extending frame according to Embodiment 2.
Fig. 8 is an illustrative configuration diagram of a screen extending frame according to Embodiment 3.
Fig. 9 is an illustrative configuration diagram of a screen extending frame according to Embodiment 4.
Fig. 10 is an illustrative configuration diagram of a screen extending frame according to Embodiment 5.
Fig. 11 is an illustrative configuration diagram of a screen extending frame according to Embodiment 6.
Fig. 12 is an illustrative configuration diagram of a screen extending frame according to Embodiment 7.
Fig. 13 is an illustrative configuration diagram of a screen extending frame according to Embodiment 8.
Fig. 14 is an illustrative configuration diagram of a screen extending frame according to Embodiment 9.
Fig. 15 is an illustrative configuration diagram of a screen extending frame according to Embodiment 10.
Fig. 16 is an illustrative configuration diagram of a screen extending frame according to Embodiment 11.
Fig. 17 is an illustrative configuration diagram of a screen extending frame according to Embodiment 12.
Fig. 18 is an illustrative configuration diagram of a screen extending frame according to Embodiment 13.
Fig. 19 is an illustrative configuration diagram of a screen extending frame according to Embodiment 14.
Fig. 20 is an illustrative configuration diagram of a screen extending frame according to Embodiment 15.
Fig. 21 is an illustrative configuration diagram of a screen extending frame according to Embodiment 16.
Fig. 22 is an illustrative configuration diagram of a screen extending frame according to Embodiment 17.
Fig. 23 is an illustrative configuration diagram of a screen extending frame according to Embodiment 18.
Fig. 24 is an illustrative configuration diagram of a screen extending frame according to Embodiment 19.
Fig. 25 is an illustrative configuration diagram of a screen extending frame according to Embodiment 20.
Fig. 26 is an illustrative configuration diagram of a screen extending frame according to Embodiment 21.
Fig. 27 is an illustrative function diagram of the screen extending frame according to Embodiment 21.
Fig. 28 is an illustrative configuration diagram of a screen extending frame according to Embodiment 22.
Fig. 29 is an illustrative function diagram of the screen extending frame according to Embodiment 22.
Fig. 30 is an illustrative configuration diagram of a screen extending frame according to Embodiment 23.
Fig. 31 is an illustrative function diagram of the screen extending frame according to Embodiment 23.

### Mode for Carrying out the Invention

Hereinafter, embodiments of the invention according to the present application are described with reference to the drawings.
A screen extending frame to be shown in embodiments is a screen extending frame in a rectangular shape and used, when a screen is attached thereto, by being mounted on a screen extending jig having an extending and reducing function. It is constituted by a first frame member and a third frame member that are arranged in parallel and have the same length, and a second frame member and a fourth frame member that are arranged in parallel and have the same length, the cross-sections of the first, the second, the third and the fourth frame members are square, one faces of the first, the second, the third and the fourth frame members are plane to which the screen is attached. A rectangular screen extending frame is formed by connecting the first and the second frame members, the second and the third frame members, the third and the fourth frame members, and the fourth and the first frame members, and the corners of the screen extending frame are configured so as to have flexibility and elasticity.

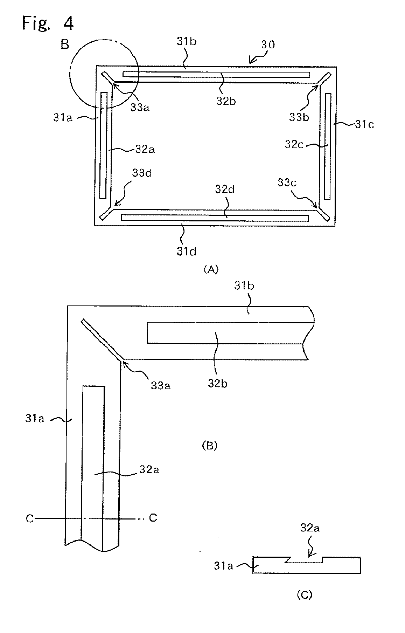

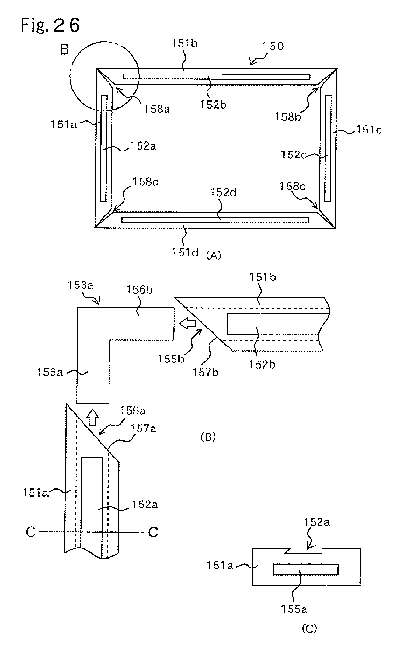

In screen extending frames of Embodiments 1 to 20 shown in Figs. 4 to 25, four frame members constituting the frame each are formed in a single unit, and in screen extending frames of Embodiments 20 to 22 shown in Figs. 26 to 31, four frame members constituting the frame each are formed in separate units.

In Embodiments 1 to 12 described with reference to Figs. 4 to 15, flexibility of the couplings of the solid screen extending frames is obtained through cut grooves formed in the couplings of the frame members in the width direction.

### Embodiment 1

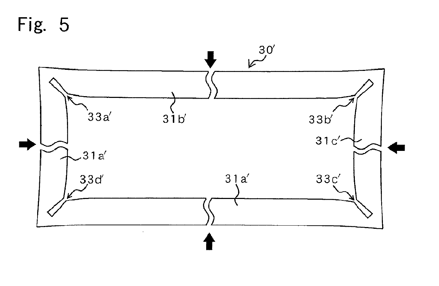

Fig. 4 shows a configuration of Embodiment 1, and Fig. 5 illustrates the function of Embodiment 1.
In Fig. 4,(A) is an overall view of a screen extending frame 30, (B) is an enlarged exploded view of a portion indicated by the dashed circle B in (A), and (C) is a cross-sectional view of the portion indicated by the dashed line C in (B).

As shown in Fig. 4 (A) of the overall view and Fig. 4 (B) of the enlarged exploded view, the screen extending frame 30 is assembled with four frame members 31a, 31b, 31c, and 31d to be formed in a rectangular shape, and structured by fixedly joined by means of welding, or the like.

On the four frame members 31a, 31b, 31c, and 31d, engagement grooves 32a, 32b, 32c, and 32d with which engagement elements formed in a screen extending jig are engaged each are formed.

A cut groove 33a in the inner side of the joint of the frame members 31a and 31b from the inner angle to the outer angle; a cut groove 33b in the inner side of the joint of the frame members 31b and 31c from the inner angle to the outer angle; a cut groove 33c in the inner side of the joint of the frame members 31c and 31d from the inner angle to the outer angle; and a cut groove 33d in the inner side of the joint of the frame members 31d and 31a from the inner angle to the outer angle are formed.

All of the four frame members 31a, 31b, 31c, and 31d have the same cross-sectional shape, the engagement groove 32a with which an engagement element of the screen extending jig is engaged is formed on one face of the frame member 31a as shown by the cross-section in Fig. 4 (C), and the opposite face is set to be a plane in order to attach the screen thereto.

When the screen is attached to the screen extending frame 30, the engagement elements of the extending jig are engaged with the engagement grooves 32a, 32b, 32c, and 32d, and the extending jig is extended and reduced, the screen extending frame 30 extends and reduces, and accordingly, the tensile force to the screen is adjusted.

The function of the screen extending frame 30 is described referring to Fig. 5.
The screen extending frame 30 configured by the joined four frame members 31a, 31b, 31c, and 31d is pressed in the directions of the black arrows using a tool such as the screen extending jig, a clamp, a vise, or the like, not shown in the drawing. For this reason, as the open ends of the cut grooves 33a, 33b, 33c, and 33d reduce, the frame members 31a, 31b, 31c, and 31d inwardly bend, and the screen extending frame 10 is reduced, and resulted a reduced screen extending frame 30' constituted by curved frame members 31a' , 31b' , 31c' , and 31d' .

Then, the screen is fixed to the reduced screen extending frame 30' by means of adhesion, or the like.

In the state where fixation of the screen to the reduced screen extending frame 30' is completed, the pressing force to the reduced screen extending frame 30' exerted by the screen extending jig, the clamp, the vice, or the like is released.

When the pressing force to the reduced screen extending frame 30' is released, the curved frame members 31a' , 31b' , 31c' , and 31d' that inwardly bend will return to the shape of the state of not being compressed, and as the open ends of the cut grooves 33a' 33b' , 33c' , and 33d' open widely, the reduced screen extending frame 30' extends, and accordingly, a tensile force is exerted on the screen attached to the screen extending frame thus extended.

Since the tensile force is exerted even in the state of not using the extending jig, it is possible to keep the screen to be in tension even in the state where the screen is simply fixed to the screen extending frame, and there occurs no sagging in the screen.

As is obvious from the above description of the function, the screen extending frame gives a tensile force on the screen even when the extending jig is not used, and therefore, it is possible to perform screen printing only with the screen extending frame alone without using the screen extending jig.

Insertion of a solid elastic element such as natural rubber or synthetic rubber or a non-solid spring such as a plate spring or a coil spring into the cut grooves 33a, 33b, 33c, and 33d enables protection of the open ends and supplementation of elasticity.

### Embodiment 2

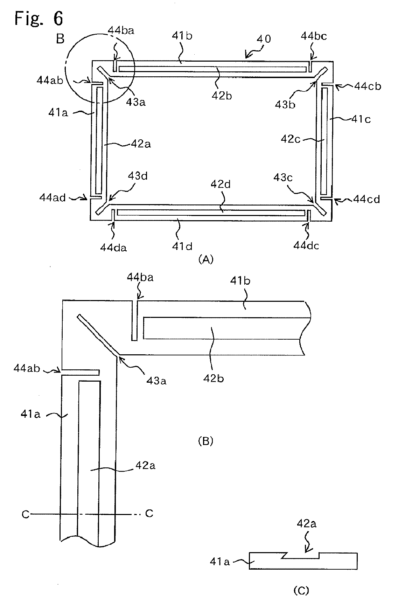

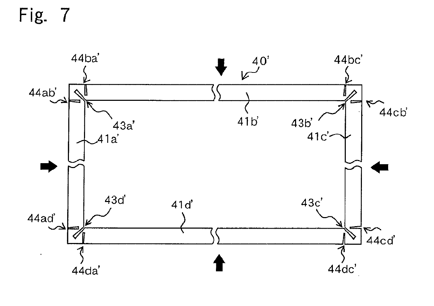

Embodiment 2 obtained by modifying Embodiment 1 is shown in Fig. 6, and the function of Embodiment 2 is described referring to Fig. 7. In the drawing, (A) is an overall view of a screen extending frame 40, (B) is an enlarged exploded view of a portion indicated by a dashed circle B in (A), and (C) is a cross-sectional view of a portion indicated by a dashed line C in (B).

As shown in Fig. 5(A) of the overall view and Fig. 5(B) of the enlarged exploded view, the screen extending frame 40 is assembled with four frame members 41a, 41b, 41c, and 41d to be formed in a rectangular shape, and structured by fixedly joined by means of welding, or the like.

On the four frame members 41a, 41b, 41c, and 41d, engagement grooves 42a, 42b, 42c, and 42d with which engagement elements formed in screen extending jig are engaged each are formed.

An inclined cut groove 43a in the inner side of the joint of the frame members 41a and 41b from the inner angle to the outer angle; a narrow inclined cut groove 43b in the inner side of the joint of the frame members 41b and 41c from the inner angle to the outer angle; a narrow inclined cut groove 43c in the inner side of the joint of the frame members 41c and 41d from the inner angle to the outer angle; and a narrow inclined cut groove 43d in the inner side of the joint of the frame members 41d and 41a from the inner angle to the outer angle are formed.

Furthermore, there are formed on the frame member 41a a narrow cut groove 44ab from the outer side orthogonally toward the inner side at the joint with the frame member 41b and a narrow cut groove 44ad from the outer side orthogonally toward the inner side at the joint thereof with the frame member 41d; on the frame member 41b a narrow cut groove 44ba from the outer side orthogonally toward the inner side at the joint with the frame member 41a and a narrow cut groove 44bc from the outer side orthogonally toward the inner side at the joint thereof with the frame member 41c; on the frame member 41c a narrow cut groove 44cb from the outer side orthogonally toward the inner side at the joint with the frame member 41b and a narrow cut groove 44cd from the outer side orthogonally toward the inner side at the joint thereof with the frame member 41d; and on the frame member 41d a narrow cut groove 44dc from the outer side orthogonally toward the inner side at the joint with the frame member 41c and a narrow cut groove 44da from the outer side orthogonally toward the inner side at the joint thereof with the frame member 41a.

All of the four frame members 41a, 41b, 41c, and 41d have the same cross-sectional shape, the engagement groove 42a with which an engagement element of the screen extending jig is engaged is formed on one face of the frame member 41a as shown by the cross-section in Fig. 6 (C), and the opposite face is set to be a plane in order to attach the screen thereto.

When the screen is attached to the screen extending frame 40, the engagement elements of the extending jig are engaged with the engagement grooves 42a, 42b, 42c, and 42d, and the extending jig is extended and reduced, the screen extending frame 40 extends and reduces, and accordingly, the tensile force to the screen is adjusted.

The function of the screen extending frame 40 is described referring to Fig. 7.
In the drawing, the screen extending frame 40 configured by the joined four frame members 41a, 41b, 41c, and 41d is pressed in the directions of the black arrows using a tool such as the screen extending jig, a clamp, a vise, or the like, not shown in the drawing. For this reason, as the open ends of the cut grooves 43a, 43b, 43c, and 43d are reduced, resulting in reduced open ends 43a' , 43b', 43c', 43d ', 43ab', 43ba', 43bc', 43cb' , 43cd', 43dc' , 43da' , and 43ad', the frame members 41a, 41b, 41c, and 41d inwardly shift, causing the screen extending frame 40 to be reduced, and resulted a reduced screen extending frame 40' constituted by reduced frame members 41a' , 41b' , 41c' , and 41d' .

The screen is, then, fixed to the screen extending frame 40' by means of adhesion, or the like.

In the state where fixation of the screen to the reduced screen extending frame 40' is completed, the pressing force to the reduced screen extending frame 40' exerted by the screen extending jig, the clamp, the vice, or the like is released.

When the pressing force to the reduced screen extending frame 40' is released, the frame members 41a' , 41b' , 41c' , and 41d' that inwardly shift will return to the shape of the state not being compressed, and as the open ends of the cut grooves 43a' , 43b' , 43c' , 43d' , 43ab' , 43ba' , 43bc' , 43cb' , 43cd' , 43dc ', 43da', and 43ad' open widely, the reduced screen extending frame 40' extends, and a tensile force is exerted on the screen fixed to the screen extending frame thus extended.

Since the tensile force is exerted even in the state of not using the extending jig, it is possible to keep the screen to be in tension even in the state where the screen is simply fixed to the screen extending frame, and there occurs no sagging in the screen.

As is obvious from the above description of the function, the screen extending frame gives the tensile force on the screen even when the extending jig is not used, and therefore, it is possible to perform screen printing only with the screen extending frame alone without using the screen extending jig.

Insertion of a solid elastic element such as natural rubber or synthetic rubber or a non-solid spring such as a plate spring or a coil spring into the cut grooves 43a, 43b, 43c, 43d, 43ab, 43ba, 43bc, 43cb, 43cd, 43dc, 43da, and 43ad enables protection of the open ends and supplementation of elasticity.

### Embodiment 3

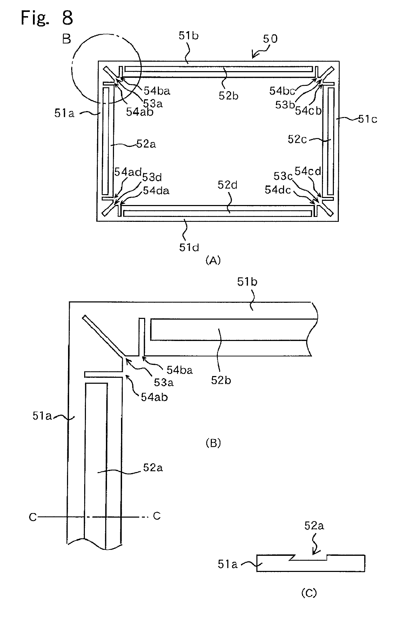

Embodiment 3 that is another Embodiment obtained by modifying Embodiment 1 is shown in Fig. 8. In the drawing, (A) is an overall view of a screen extending frame 50, (B) is an enlarged exploded view of a portion indicated by a dashed circle B in (A), and (C) is a cross-sectional view of a portion indicated by a dashed line C in (B).

As shown in Fig. 8 (A) of the overall view and Fig. 8 (B) of the enlarged exploded view, the screen extending frame 50 is assembled with four frame members 51a, 51b, 51c, and 51d to be formed in a rectangular shape, and structured by fixedly joined by means of welding, or the like.

On the four frame members 51a, 51b, 51c, and 51d, engagement grooves 52a, 52b, 52c, and 52d with which engagement elements formed in a screen extending jig are engaged each are formed.

There are formed a narrow inclined cut groove 53a in the inner side of the joint of the frame members 51a and 51b from the inner angle to the outer angle; a narrow inclined cut groove 53b in the inner side of the joint of the frame members 51b and 51c from the inner angle to the outer angle; a narrow inclined cut groove 53c in the inner side of the joint of the frame members 51c and 51d from the inner angle to the outer angle; and a narrow inclined cut groove 53d in the inner side of the joint of the frame members 51d and 51a from the inner angle to the outer angle.

Furthermore, there are formed on the frame member 51a a cut groove 54ab that is orthogonal to the outer side from the inner side of the joint with the frame member 51b and a narrow cut groove 54ad that is orthogonal to the outer side from the inner side of the joint thereof with the frame member 51d; on the frame member 51b a narrow cut groove 54ba that is orthogonal to the outer side from the inner side of the joint with the frame member 51a and a narrow cut groove 54bc that is orthogonal to the outer side from the inner side of the joint thereof with the frame member 51c; on the frame member 51c a narrow cut groove 54cb that is orthogonal to the outer side from the inner side of the joint with the frame member 51b and a narrow cut groove 54cd that is orthogonal to the outer side from the inner side of the joint thereof with the frame member 51d; and on the frame member 51d a narrow cut groove 54dc that is orthogonal to the outer side from the inner side of the joint with the frame member 51c and a narrow cut groove 54da that is orthogonal to the outer side from the inner side of the joint thereof with the frame member 51a.

All of the four frame members 51a, 51b, 51c, and 51d have the same cross-sectional shape, the engagement groove 52a with which an engagement element of the screen extending jig is engaged is formed on one face of the frame member 51a as shown by the cross-section in Fig. 8 (C), and the opposite face is set to be a plane in order to attach the screen thereto.

When the screen is attached to the screen extending frame 50, the engagement elements of the extending jig are engaged with the engagement grooves 52a, 52b, 52c, and 52d, and the extending jig is extended and reduced, the screen extending frame 50 extends and reduces, and accordingly, the tensile force to the screen is adjusted.

When the screen extending frame 50 configured by combining the four frame members 51a, 51b, 51c, and 51d is pressed in the inward direction using a tool such as the screen extending jig, a clamp, a vise, or the like, the open ends of the cut grooves 53a, 54ab, 54ba, 53b, 54bc, 54cb, 53c, 54cd, 54dc, 53d, 54da, and 54ad that are formed inner side are reduced, the frame members 51a, 51b, 51c, and 51d inwardly bend, and accordingly, the screen extending frame 50 is reduced.

The screen is, then, fixed to the screen extending frame by means of adhesion, or the like.

In the state where fixation of the screen to the reduced screen extending frame is completed, the pressing force to the reduced screen extending frame exerted by the screen extending jig, the clamp, the vice, or the like is released.

As a result of releasing the pressing force to the reduced screen extending frame, the frame members that inwardly bend will return to the shape of the state not being compressed, and as the open ends of the cut grooves 53a, 54ab, 54ba, 53b, 54bc, 54cb, 53c, 54cd, 54dc, 53d, 54da, and 54ad open widely, thereby the frame members 51a, 51b, 51c, and 51d outwardly extend, causing the screen extending frame 50 to extend, and a tensile force is exerted on the screen attached to the extended screen extending frame.

Since the tensile force is exerted even in the state of not using the extending jig, it is possible to keep the screen to be in tension even in the state where the screen is simply fixed to the screen extending frame, and there occurs no sagging in the screen.

Insertion of a solid elastic element such as natural rubber or synthetic rubber or a non-solid spring such as a plate spring or a coil spring into the cut grooves 53a, 53b, 53c, 53d, 54ab, 54ba, 54bc, 54cb, 54cd, 54dc, 54da, and 54ad enables protection of the open ends and supplementation of elasticity.

### Embodiment 4

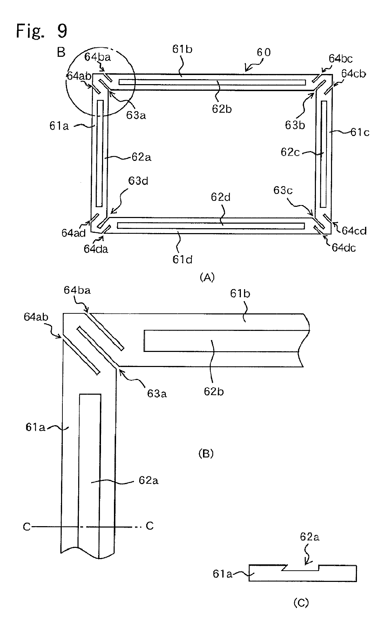

Embodiment 4 that is another Embodiment obtained by modifying Embodiment 1 is shown in Fig. 9.
Description of the function corresponding to that of Fig. 5 or Fig. 7 is omitted.
In Fig. 9,(A) is an overall view of a screen extending frame 60, (B) is an enlarged exploded view of a portion indicated by a dashed circle B in (A), and (C) is a cross-sectional view of a portion indicated by a dashed line C in (B).

As shown in Fig. 9 (A) of the overall view and Fig. 9 (B) of the enlarged exploded view, the screen extending frame 60 is assembled with four frame members 61a, 61b, 61c, and 61d to be formed in a rectangular shape, and structured by fixedly joined by means of welding, or the like.

On the four frame members 61a, 61b, 61c, and 61d, engagement grooves 62a, 62b, 62c, and 62d with which engagement elements formed in a screen extending jig are engaged each are formed.

There are formed a narrow inclined cut groove 63a in the outer side of the joint of the frame members 61a and 61b from the outer angle to the inner angle; a narrow inclined cut groove 63b in the outer side of the joint of the frame members 61b and 61c from the outer angle to the inner angle; a narrow inclined cut groove 63c in the outer side of the joint of the frame members 61c and 61d from the outer angle to the inner angle; and a narrow inclined cut groove 63d in the outer side of the joint of the frame members 61d and 61a from the outer angle to the inner angle.

Furthermore, there are formed on the frame member 61a a narrow inclined cut groove 64ab from the outer side toward the inner side of the joint with the frame member 61b and a narrow inclined cut groove 64ad from the outer side toward the inner side of the joint thereof with the frame member 61d; on the frame member 61b a narrow inclined cut groove 64ba from the outer side toward the inner side of the joint with the frame member 61a and a narrow inclined cut groove 64bc from the outer side toward the inner side of the joint thereof with the frame member 61c; on the frame member 61c a narrow inclined cut groove 64cb from the outer side toward the inner side of the joint with the frame member 61b and a narrow inclined cut groove 64cd from the outer side toward the inner side of the joint thereof with the frame member 61d; and on the frame member 61d a narrow inclined cut groove 64dc from the outer side toward the inner side of the joint with the frame member 61c and a narrow inclined cut groove 64da from the outer side toward the inner side of the joint thereof with the frame member 61a.

All of the four frame members 61a, 61b, 61c, and 61d have the same cross-sectional shape, the engagement groove 62a with which an engagement element of the screen extending jig is engaged is formed on one face of the frame member 61a as shown by the cross-section in Fig. 9 (C), and the opposite face is set to be a plane in order to attach the screen thereto.

When the screen is attached to the screen extending frame 60, the engagement elements of the extending jig are engaged with the engagement grooves 62a, 62b, 62c, and 62d, and the extending jig is extended and reduced, the screen extending frame 60 extends and reduces, and accordingly, the tensile force to the screen is adjusted.

When the screen extending frame 60 configured by combining the four frame members 61a, 61b, 61c, and 61d is pressed in the inward direction using a tool such as the screen extending jig, a clamp, a vise, or the like, the open ends of the cut grooves 63a, 63b, 63c, and 63d that are formed in the inner side are reduced, the open ends of the cut grooves 64ab, 64ba, 64bc, 64cb, 64cd, 64dc, 64da, and 64ad that are formed in the outer side open widely, and accordingly, the frame members 61a, 61b, 61c, and 61d inwardly bend, causing the screen extending frame 60 to be reduced.

The screen is, then, fixed to the reduced screen extending frame by means of adhesion, or the like.

In the state where fixation of the screen to the reduced screen extending frame is completed, the pressing force to the reduced screen extending frame exerted by the screen extending jig, the clamp, the vice, or the like is released.

As a result of releasing the pressing force to the reduced screen extending frame, the frame members that inwardly bend will all return to the shape of the state not being compressed, and as the open ends of the cut grooves 63a, 63b, 63c, and 63d that are formed in the inner side are widely open and the open ends of the cut grooves 44ab, 64ba, 64bc, 64cb, 64cd, 64dc, 64da, and 64ad that are formed in the outer side are reduced, thereby the frame members 61a, 61b, 61c, and 61d extend to the outer side to extend the screen extending frame 60, and therefore, a tensile force is exerted on the screen attached to the extended screen extending frame.

Since the tensile force is exerted even in the state of not using the extending jig, it is possible to keep the screen to be in tension even in the state where the screen is simply fixed to the screen extending frame, and there occurs no sagging in the screen.

Insertion of a solid elastic element such as natural rubber or synthetic rubber or a non-solid spring such as a plate spring or a coil spring into the cut grooves 63a, 63b, 63c, 63d, 64ab, 64ba, 64bc, 64cb, 64cd, 64dc, 64da, and 64ad enables protection of the open ends and supplementation of elasticity.

### Embodiment 5

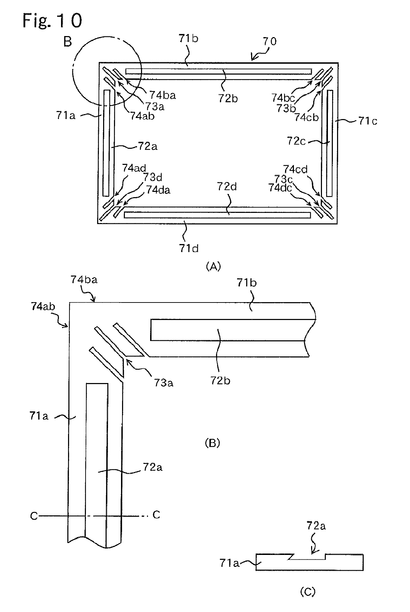

Embodiment 5 that is another example obtained by modifying Embodiment 1 is shown in Fig. 10.
Description of the function corresponding to that of Fig. 5 or Fig. 7 is omitted.
In Fig. 10, (A) is an overall view of a screen extending frame 70, (B) is an enlarged exploded view of a portion indicated by a dashed circle B in (A), and (C) is a cross-sectional view of a portion indicated by a dashed line C in (B).

As shown in Fig. 10 (A) of the overall view and Fig. 10 (B) of the enlarged exploded view, the screen extending frame 70 is assembled with four frame members 71a, 71b, 71c, and 71d to be formed in a rectangular shape, and structured by fixedly joined by means of welding, or the like.

On the four frame members 71a, 71b, 71c, and 71d, engagement grooves 72a, 72b, 72c, and 72d with which engagement elements formed in a screen extending jig are engaged each are formed.

There are formed a narrow inclined cut groove 73a in the outer side of the joint of the frame members 71a and 71b from the outer angle to the inner angle; a narrow inclined cut groove 73b in the outer side of the joint of the frame members 71b and 71c from the outer angle to the inner angle; a narrow inclined cut groove 73c in the outer side of the joint of the frame members 71c and 71d from the outer angle to the inner angle; and a narrow inclined cut groove 73d in the outer side of the joint of the frame members 71d and 71a from the outer angle to the inner angle.

Furthermore, there are formed on the frame member 71a a narrow inclined cut groove 74ab from the inner side toward the outer side of the joint with the frame member 71b and a narrow inclined cut groove 74ad from the inner side toward the outer side of the joint thereof with the frame member 71d; on the frame member 71b a narrow inclined cut groove 74ba from the inner side toward the outer side of the joint with the frame member 71a and a narrow inclined cut groove 74bc from the inner side toward the outer side of the joint thereof with the frame member 71c; on the frame member 71c a narrow inclined cut groove 74cb from the inner side toward the outer side of the joint with the frame member 71b and a narrow inclined cut groove 74cd from the inner side toward the outer side of the joint thereof with the frame member 71d; and on the frame member 71d a narrow inclined cut groove 74dc from the inner side toward the outer side of the joint with the frame member 71c and a narrow inclined cut groove 74da from the inner side toward the outer side of the joint thereof with the frame member 71a.

All of the four frame members 71a, 71b, 71c, and 71d have the same cross-sectional shape, the engagement groove 72a with which an engagement element of the screen extending jig is engaged is formed on one face of the frame member 71a as shown by the cross-section in Fig. 10 (C), and the opposite face is set to be a plane in order to attach the screen thereto.

When the screen is attached to the screen extending frame 70, the engagement elements of the extending jig are engaged with the engagement grooves 72a, 72b, 72c, and 72d, and the extending jig is extended and reduced, the screen extending frame 70 extends and reduces, and accordingly, the tensile force to the screen is adjusted.

When the screen extending frame 70 configured by combining the four frame members 71a, 71b, 71c, and 71d is pressed in the inward direction using a tool such as the screen extending jig, a clamp, a vise, or the like, the open ends of the cut grooves 73a, 73b, 73c, 73d, 74ab, 74ba, 74bc, 74cb, 74cd, 74dc, 74da, and 74ad are reduced, and accordingly, the frame members 71a, 71b, 71c, and 71d inwardly bend, causing the screen extending frame 70 to be reduced.

The screen is, then, fixed to the reduced screen extending frame by means of adhesion, or the like.

In the state where fixation of the screen to the reduced screen extending frame is completed, the pressing force to the reduced screen extending frame exerted by the screen extending jig, the clamp, the vice, or the like is released.

As a result of releasing the pressing force to the reduced screen extending frame, the frame members that inwardly bend will all return to the shape of the state not being compressed, and as the open ends of the cut grooves 73a, 73b, 73c, 73d, 74ab, 74ba, 74bc, 74cb, 74cd, 74dc, 74da, and 74ad are widely open, the frame members 71a, 71b, 71c, and 71d extend to the outer side to extend the screen extending frame 70, and therefore, a tensile force is exerted on the screen attached to the screen extending frame thus extended.

Since the tensile force is exerted even in the state of not using the extending jig, it is possible to keep the screen to be in tension even in the state where the screen is simply fixed to the screen extending frame, and there occurs no sagging in the screen.

Insertion of a solid elastic element such as natural rubber or synthetic rubber or a non-solid spring such as a plate spring or a coil spring into the cut grooves 73a, 73b, 73c, 73d, 74ab, 74ba, 74bc, 74cb, 74cd, 74dc, 74da, and 74ad enables protection of the open ends and supplementation of elasticity.

### Embodiment 6

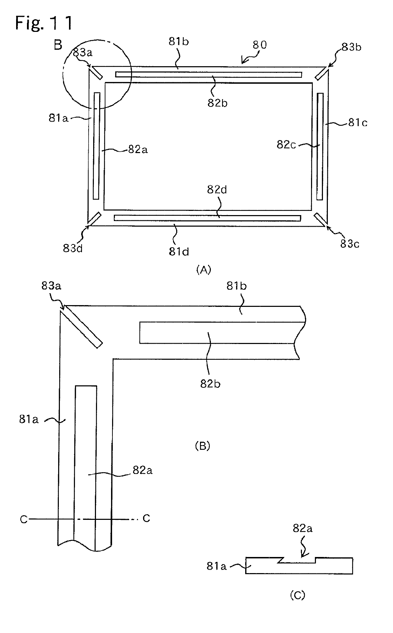

The configuration of Embodiment 6 is shown in Fig. 11.
Description of the function corresponding to that of Fig. 5 or Fig. 7 is omitted.
In Fig. 11, (A) is an overall view of a screen extending frame 80, (B) is an enlarged exploded view of a portion indicated by a dashed circle B in (A), and (C) is a cross-sectional view of a portion indicated by a dashed line C in (B).

As shown in Fig. 11 (A) of the overall view and Fig. 11 (B) of the enlarged exploded view, the screen extending frame 80 is assembled with four frame members 81a, 81b, 81c, and 81d to be formed in a rectangular shape, and structured by fixedly joined by means of welding, or the like.

On the four frame members 81a, 81b, 81c, and 81d, engagement grooves 82a, 82b, 82c, and 82d with which engagement elements formed in a screen extending jig are engaged each are formed.

There are formed a narrow cut groove 83a in the outer side of the joint of the frame members 81a and 81b from the outer angle toward the inner angle; a narrow cut groove 83b in the outer side of the joint of the frame members 81b and 81c from the outer angle toward the inner angle; a narrow cut groove 83c in the outer side of the joint of the frame members 81c and 81d from the outer angle toward the inner angle; and a narrow cut groove 83d in the outer side of the joint of the frame members 81d and 81a from the outer angle toward the outer angle.

All of the four frame members 81a, 81b, 81c, and 81d have the same cross-sectional shape, the engagement groove 82a with which an engagement element of the screen extending jig is engaged is formed on one face of the frame member 81a as shown by the cross-section in Fig. 11 (C), and the opposite face is set to be a plane in order to attach the screen thereto.

When the screen is attached to the screen extending frame 80, the engagement elements of the extending jig are engaged with the engagement grooves 82a, 82b, 82c, and 82d, and then the extending jig is extended and reduced, the screen extending frame 80 extends and reduces, and accordingly, the tensile force to the screen is adjusted.

When the screen extending frame 80 configured by combining the four frame members 81a, 81b, 81c, and 81d is pressed in the inward direction using a tool such as the screen extending jig, a clamp, a vise, or the like, the open ends of the cut grooves 83a, 83b, 83c, and 83d are reduced, and accordingly, the frame members 81a, 81b, 81c, and 81d inwardly bend, causing the screen extending frame 80 to be reduced.

The screen is, then, fixed to the reduced screen extending frame by means of adhesion, or the like.

In the state where fixation of the screen to the reduced screen extending frame is completed, the pressing force to the reduced screen extending frame exerted by the screen extending jig, the clamp, the vice, or the like is released.

As a result of releasing the pressing force to the reduced screen extending frame, the frame members that inwardly bend will all return to the shape of the state of not being compressed, and as the open ends of the cut grooves 83a, 83b, 83c, and 83d, are widely open, the frame members 81a, 81b, 81c, and 81d extend to the outer side to extend the screen extending frame 80, and therefore, a tensile force is exerted on the screen attached to the extended screen extending frame.

Since the tensile force is exerted even in the state of not using the extending jig, it is possible to keep the screen to be in tension even in the state where the screen is simply fixed to the screen extending frame, and there occurs no sagging in the screen.

### Embodiment 7

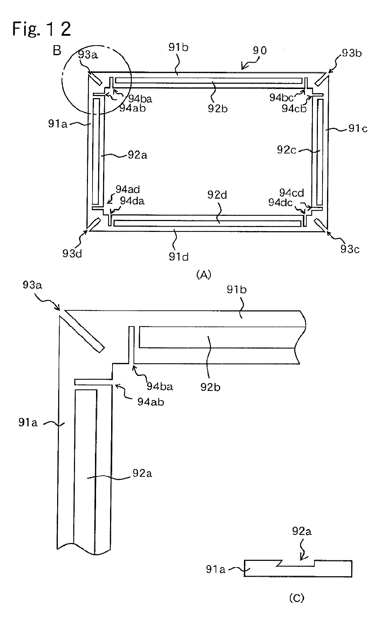

Embodiment 7 that is obtained by modifying Embodiment 6 is shown in Fig. 12.
Description of the function corresponding to that of Fig. 5 or Fig. 7 is omitted.
In Fig. 12, (A) is an overall view of a screen extending frame 90, (B) is an enlarged exploded view of a portion indicated by a dashed circle B in (A), and (C) is a cross-sectional view of a portion indicated by a dashed line C in (B).

As shown in Fig. 12 (A) of the overall view and Fig. 12(B) of the enlarged exploded view, the screen extending frame 90 is assembled with four frame members 91a, 91b, 91c, and 91d to be formed in a rectangular shape, and structured by fixedly joined by means of welding, or the like.

On the four frame members 91a, 91b, 91c, and 91d, engagement grooves 92a, 92b, 92c, and 92d with which engagement elements formed in a screen extending jig are engaged each are formed.

There are formed a narrow inclined cut groove 93a in the outer side of the joint of the frame members 91a and 91b from the outer angle toward the inner angle; a narrow inclined cut groove 93b in the outer side of the joint of the frame members 91b and 91c from the outer angle toward the inner angle; a narrow inclined cut groove 93c in the outer side of the joint of the frame members 91c and 91d from the outer angle toward the inner angle; and a narrow inclined cut groove 93d in the outer side of the joint of the frame members 91d and 91a from the outer angle to the inner angle.

Furthermore, there are formed on the frame member 91a a narrow cut groove 94ab that is orthogonal to the outer side from the inner side at the joint with the frame member 91b and a narrow cut groove 94ad that is orthogonal to the outer side from the inner side at the joint thereof with the frame member 91d; on the frame member 91b a narrow cut groove 94ba that is orthogonal to the outer side from the inner side at the joint with the frame member 91a and a narrow cut groove 94bc that is orthogonal to the outer side from the inner side at the joint thereof with the frame member 91c; on the frame member 91c a narrow cut groove 94cb that is orthogonal to the outer side from the inner side at the joint with the frame member 91b and a narrow cut groove 94cd that is orthogonal to the outer side from the inner side at the joint thereof with the frame member 91d; and on the frame member 91d a narrow cut groove 94dc that is orthogonal to the outer side from the inner side at the joint with the frame member 91c and a narrow cut groove 94da that is orthogonal to the outer side from the inner side at the joint thereof with the frame member 91a.

All of the four frame members 91a, 91b, 91c, and 91d have the same cross-sectional shape, the engagement groove 92a with which an engagement element of the screen extending jig is engaged is formed on one face of the frame member 91a as shown by the cross-section in Fig. 12 (C), and the opposite face is set to be a plane in order to attach the screen thereto.

When the screen is attached to the screen extending frame 90, the engagement elements of the extending jig are engaged with the engagement grooves 92a, 92b, 92c, and 92d, and the extending jig is extended and reduced, the screen extending frame 90 extends and reduces, and accordingly, the tensile force to the screen is adjusted.

When the screen extending frame 90 configured by combining the four frame members 91a, 91b, 91c, and 91d is pressed in the inward direction using a tool such as the screen extending jig, a clamp, a vise, or the like, the open ends of the cut grooves 93a, 93b, 93c, and 93d that are formed in the outer side are open wide, the open ends of the cut grooves 94ab, 94ba, 94bc, 94cb, 94cd, 94dc, 94da, and 94ad that are formed in the inner side are reduced, and accordingly, the frame members 91a, 91b, 91c, and 91d inwardly bend, causing the screen extending frame 10 to be reduced.

The screen is, then, fixed to the reduced screen extending frame by means of adhesion, or the like.

In the state where fixation of the screen to the reduced screen extending frame is completed, the pressing force to the reduced screen extending frame exerted by the screen extending jig, the clamp, the vice, or the like is released.

As a result of releasing the pressing force to the reduced screen extending frame, the frame members that inwardly bend will all return to the shape of the state of not being compressed, and as the open ends of the cut grooves 93a, 93b, 93c, and 93d are reduced and the open ends of the cut grooves 94ab, 94ba, 94bc, 94cb, 94cd, 94dc, 94da, and 94ad are widely open, the frame members 91a, 91b, 91c, and 91d extend to extend the screen extending frame 90, and therefore, a tensile force is exerted on the screen attached to the extended screen extending frame.

Since the tensile force is exerted even in the state of not using the extending jig, it is possible to keep the screen to be in tension even in the state where the screen is simply fixed to the screen extending frame, and there occurs no sagging in the screen.

Insertion of a solid elastic element such as natural rubber or synthetic rubber or a non-solid spring such as a plate spring or a coil spring into the cut grooves 93a, 93b, 93c, 93d, 94ab, 94ba, 94bc, 94cb, 94cd, 94dc, 94da, and 94ad enables protection of the open ends and supplementation of elasticity.

### Embodiment 8

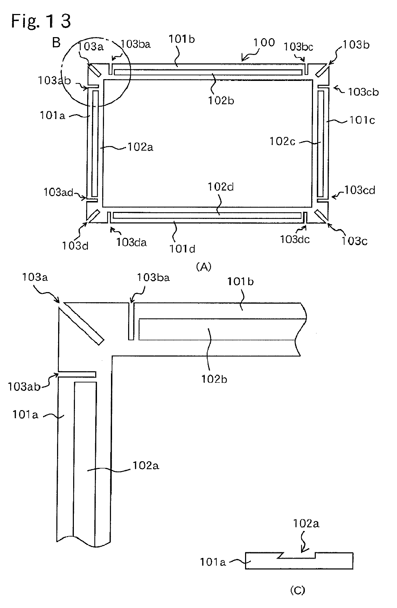

Embodiment 8 that is another example obtained by modifying Embodiment 6 is shown in Fig. 13.
Description of the function corresponding to that of Fig. 5 or Fig. 7 is omitted.
In Fig. 13, (A) is an overall view of a screen extending frame 100, (B) is an enlarged exploded view of a portion indicated by a dashed circle B in (A), and (C) is a cross-sectional view of a portion indicated by a dashed line C in (B).

As shown in Fig. 13 (A) of the overall view and Fig. 13(B) of the enlarged exploded view, the screen extending frame 100 is assembled with four frame members 101a, 101b, 101c, and 101d to be formed in a rectangular shape, and structured by fixedly joined by means of welding, or the like.

On the four frame members 101a, 101b, 101c, and 101d, engagement grooves 102a, 102b, 102c, and 102d with which engagement elements formed in a screen extending jig are engaged each are formed.

There are formed a narrow inclined cut groove 103a in the outer side of the joint of the frame members 101a and 101b from the outer angle to the inner angle; a narrow inclined cut groove 103b in the outer side of the joint of the frame members 101b and 101c from the outer angle to the inner angle; a narrow inclined cut groove 103c in the outer side of the joint of the frame members 101c and 101d from the outer angle to the inner angle; and a narrow inclined cut groove 103d in the outer side of the joint of the frame members 101d and 101a from the outer angle to the inner angle.

Furthermore, there are formed on the frame member 101a a cut groove 104ab that is orthogonal to the inner side from the outer side at the joint with the frame member 101b and a cut groove 104ad that is orthogonal to the inner side from the outer side at the joint thereof with the frame member 101d; on the frame member 101b a cut groove 104ba that is orthogonal to the inner side from the outer side at the joint with the frame member 101 and a cut groove 104bc that is orthogonal to the inner side from the outer side at the joint thereof with the frame member 101c; on the frame member 101c a cut groove 104cb that is orthogonal to the inner side from the outer side at the joint with the frame member 101b and a cut groove 104cd that is orthogonal to the inner side from the outer side at the joint thereof with the frame member 101d; and on the frame member 101d a cut groove 104dc that is orthogonal to the inner side from the outer side at the joint with the frame member 101c and a cut groove 104da that is orthogonal to the inner side from the outer side at the joint thereof with the frame member 101a.

All of the four frame members 101a, 101b, 101c, and 101d have the same cross-sectional shape, the engagement groove 102a with which an engagement element of the screen extending jig is engaged is formed on one face of the frame member 101a as shown by the cross-section in Fig. 13 (C), and the opposite face is set to be a plane in order to attach the screen thereto.

When the screen is attached to the screen extending frame 100, the engagement elements of the extending jig are engaged with the engagement grooves 102a, 102b, 102c, and 102d, and the extending jig is extended and reduced, the screen extending frame 100 extends and reduces, and accordingly, the tensile force to the screen is adjusted.

When the screen extending frame 100 configured by combining the four frame members 101a, 101b, 101c, and 101d is pressed in the inward direction using a tool such as the screen extending jig, a clamp, a vise, or the like, the open ends of the cut grooves 103a, 103b, 103c, and 103d are widely open, and open ends of the cut grooves 104ab, 104ba, 104bc, 104cb, 104cd, 104dc, 104da, and 104ad are reduced, and accordingly, the frame members 101a, 101b, 101c, and 101d inwardly bend, causing the screen extending frame 100 to be reduced.

The screen is, then, fixed to the reduced screen extending frame by means of adhesion, or the like.

In the state where fixation of the screen to the reduced screen extending frame is completed, the pressing force to the reduced screen extending frame exerted by the screen extending jig, the clamp, the vice, or the like is released.

As a result of releasing the pressing force to the reduced screen extending frame, the frame members that inwardly bend will all return to the shape of the state of not being compressed, and as the open ends of the cut grooves 103a, 103b, 103c, and 103d are reduced and the open ends of the cut grooves 104ab, 104ba, 104bc, 104cb, 104cd, 104dc, 104da, and 104ad are reduced, the frame members 101a, 101b, 101c, and 101d outwardly extend to extend the screen extending frame 100, and therefore, a tensile force is exerted on the screen attached to the screen extending frame thus extended.

Since the tensile force is exerted even in the state of not using the extending jig, it is possible to keep the screen to be in tension even in the state where the screen is simply fixed to the screen extending frame, and there occurs no sagging in the screen.

Insertion of a solid elastic element such as natural rubber or synthetic rubber or a non-solid spring such as a plate spring or a coil spring into the cut grooves 103a, 103b, 103c, 103d, 104ab, 104ba, 104bc, 104cb, 104cd, 104dc, 104da, and 104ad enables protection of the open ends and supplementation of elasticity.

### Embodiment 9

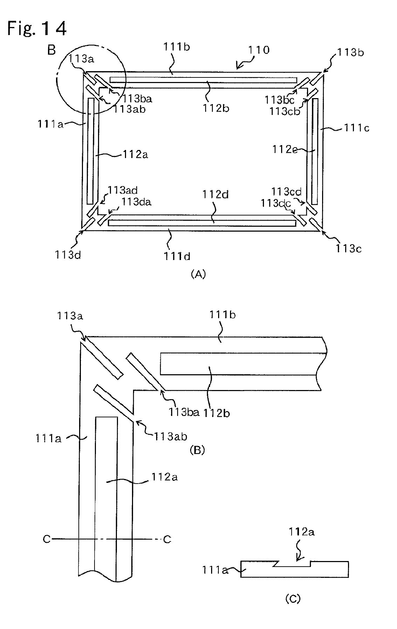

Embodiment 9 that is another example obtained by modifying Embodiment 6 is shown in Fig. 14.
Description of the function corresponding to that of Fig. 5 or Fig. 7 is omitted.
In Fig. 14, (A) is an overall view of a screen extending frame 110, (B) is an enlarged exploded view of a portion indicated by a dashed circle B in (A), and (C) is a cross-sectional view of a portion indicated by a dashed line C in (B).

As shown in Fig. 14 (A) of the overall view and Fig. 14 (B) of the enlarged exploded view, the screen extending frame 110 is assembled with four frame members 111a, 111b, 111c, and 111d to be formed in a rectangular shape, and structured by fixedly joined by means of welding, or the like.

On the four frame members 111a, 111b, 111c, and 111d, engagement grooves 112a, 112b, 112c, and 112d with which engagement elements formed in a screen extending jig are engaged each are formed.

There are formed a narrow inclined cut groove 113a in the outer side of the joint of the frame members 111a and 111b from the outer angle to the inner angle; a narrow inclined cut groove 113b in the outer side of the joint of the frame members 111b and 111c from the outer angle to the inner angle; a narrow inclined cut groove 113c in the outer side of the joint of the frame members 111c and 111d from the outer angle to the inner angle; and a narrow inclined cut groove 113d in the outer side of the joint of the frame members 111d and 111a from the outer angle to the inner angle.

Furthermore, there are formed on the frame member 111a a narrow inclined cut groove 114ab that leads to the outer side from the inner side of the joint with the frame member 111b and a narrow inclined cut groove 114ad that leads to the outer side from the inner side of the joint thereof with the frame member 111d; on the frame member 111b a narrow inclined cut groove 114ba that leads to the outer side from the inner side of the joint with the frame member 111a and a narrow inclined cut groove 114bc that leads to the outer side from the inner side of the joint thereof with the frame member 111c; on the frame member 111c a narrow inclined cut groove 114cb that leads to the outer side from the inner side of the joint with the frame member 111b and a narrow inclined cut groove 114cd that leads to the outer side from the inner side of the joint thereof with the frame member 111d; and on the frame member 111d a narrow inclined cut groove 114dc that leads to the outer side from the inner side of the joint with the frame member 111c and a narrow inclined cut groove 114da that leads to the outer side from the inner side of the joint thereof with the frame member 111a.

All of the four frame members 111a, 111b, 111c, and 111d have the same cross-sectional shape, the engagement groove 112a with which an engagement element of the screen extending jig is engaged is formed on one face of the frame member 111a as shown by the cross-section in Fig. 14 (C), and the opposite face is set to be a plane in order to attach the screen thereto.

When the screen is attached to the screen extending frame 110, the engagement elements of the extending jig are engaged with the engagement grooves 112a, 112b, 112c, and 112d, and the extending jig is extended and reduced, the screen extending frame 110 extends and reduces, and accordingly, the tensile force to the screen is adjusted.

When the screen extending frame 110 configured by combining the four frame members 111a, 111b, 111c, and 111d is pressed in the inward direction using a tool such as the screen extending jig, a clamp, a vise, or the like, the open ends of the cut grooves 113a, 113b, 113c, and 113d that are formed in the outer side are widely open, and open ends of the cut grooves 114ab, 114ba, 114bc, 114cb, 114cd, 114dc, 114da, and 114ad that are formed in the inner side are reduced, and accordingly, the frame members 111a, 111b, 111c, and 111d inwardly bend, causing the screen extending frame 110 to be reduced.

The screen is, then, fixed to the reduced screen extending frame by means of adhesion, or the like.

In the state where fixation of the screen to the reduced screen extending frame is completed, the pressing force to the reduced screen extending frame exerted by the screen extending jig, the clamp, the vice, or the like is released.

As a result of releasing the pressing force to the reduced screen extending frame, the frame members that inwardly bend will all return to the shape of the state not being compressed, and as the open ends of the cut grooves 113a, 113b, 113c, and 113d that are formed in the outer side are reduced and the open ends of the cut grooves 114ab, 114ba, 114bc, 114cb, 114cd, 114dc, 114da, and 114ad that are formed in the inner side are widely open, the frame members 111a, 111b, 111c, and 111d extend outwardly to extend the screen extending frame 110, and therefore, a tensile force is exerted on the screen attached to the screen extending frame thus extended.

Since the tensile force is exerted even in the state of not using the extending jig, it is possible to keep the screen to be in tension even in the state where the screen is simply fixed to the screen extending frame, and there occurs no sagging in the screen.

Insertion of a solid elastic element such as natural rubber or synthetic rubber or a non-solid spring such as a plate spring or a coil spring into the cut grooves 113a, 113b, 113c, 113d, 114ab, 114ba, 114bc, 114cb, 114cd, 114dc, 114da, and 114ad enables protection of the open ends and supplementation of elasticity.

### Embodiment 10

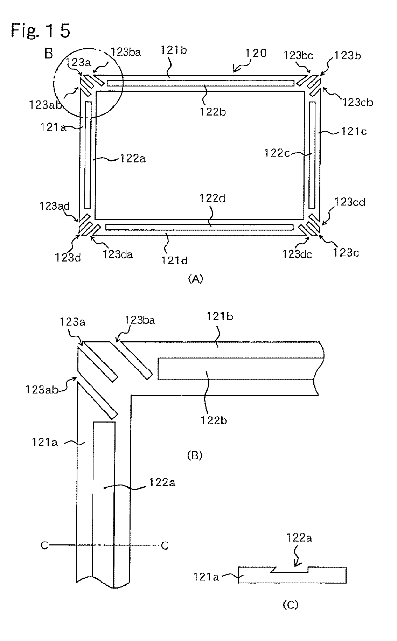

Embodiment 10 that is another example obtained by modifying Embodiment 6 is shown in Fig. 15.
Description of the function corresponding to that of Fig. 5 or Fig. 7 is omitted.
In Fig. 15, (A) is an overall view of a screen extending frame 120, (B) is an enlarged exploded view of a portion indicated by a dashed circle B in (A), and (C) is a cross-sectional view of a portion indicated by a dashed line C in (B).

As shown in Fig. 15 (A) of the overall view and Fig. 15 (B) of the enlarged exploded view, the screen extending frame 120 is assembled with four frame members 121a, 121b, 121c, and 121d to be formed in a rectangular shape, and structured by fixedly joined by means of welding, or the like.

On the four frame members 121a, 121b, 121c, and 121d, engagement grooves 122a, 122b, 122c, and 122d with which engagement elements formed in a screen extending jig are engaged each are formed.

There are formed a narrow inclined cut groove 123a in the outer side of the joint of the frame members 121a and 121b from the outer angle to the inner angle; a narrow inclined cut groove 123b in the outer side of the joint of the frame members 121b and 121c from the outer angle to the inner angle; a narrow inclined cut groove 123c in the outer side of the joint of the frame members 121c and 121d from the outer angle to the inner angle; and a narrow inclined cut groove 123d in the outer side of the joint of the frame members 121d and 121a from the outer angle to the inner angle.

Furthermore, there are formed on the frame member 121a a narrow inclined cut groove 124ab that leads to the inner side from the outer side at the joint with the frame member 121b and a narrow inclined cut groove 124ad that leads to the inner side from the outer side at the joint thereof with the frame member 121d; on the frame member 121b a narrow inclined cut groove 124ba that leads to the inner side from the outer side at the joint with the frame member 121a and a narrow inclined cut groove 124bc that leads to the inner side from the outer side at the joint thereof with the frame member 121c; on the frame member 121c a narrow inclined cut groove 124cb that leads to the inner side from the outer side at the joint with the frame member 121b and a narrow inclined cut groove 124cd that leads to the inner side from the outer side at the joint thereof with the frame member 121d; and on the frame member 121d a narrow inclined cut groove 124dc that leads to the inner side from the outer side at the joint with the frame member 121c and a narrow inclined cut groove 124da that leads to the inner side from the outer side at the joint thereof with the frame member 121a.

All of the four frame members 121a, 121b, 121c, and 121d have the same cross-sectional shape, the engagement groove 122a with which an engagement element of the screen extending jig is engaged is formed on one face of the frame member 121a as shown by the cross-section in Fig. 15 (C), and the opposite face is set to be a plane in order to attach the screen thereto.

When the screen is attached to the screen extending frame 120, the engagement elements of the extending jig are engaged with the engagement grooves 122a, 122b, 122c, and 122d, and the extending jig is extended and reduced, the screen extending frame 120 extends and reduces, and accordingly, the tensile force to the screen is adjusted.

When the screen extending frame 120 configured by combining the four frame members 121a, 121b, 121c, and 121d is pressed in the inward direction using a tool such as the screen extending jig, a clamp, a vise, or the like, the open ends of the cut grooves 123a, 123b, 123c, 123d, 124ab, 124ba, 124bc, 124cb, 124cd, 124dc, 124da, and 124ad are widely open, and accordingly, the frame members 121a, 121b, 121c, and 121d inwardly bend, causing the screen extending frame 120 to be reduced.

The screen is, then, fixed to the reduced screen extending frame by means of adhesion, or the like.

In the state where fixation of the screen to the reduced screen extending frame is completed, the pressing force to the reduced screen extending frame exerted by the screen extending jig, the clamp, the vice, or the like is released.

As a result of releasing the pressing force to the reduced screen extending frame, the frame members that inwardly bend will all return to the shape of the state not being compressed, and as the open ends of the cut grooves 123a, 123b, 123c, 123d, 124ab, 124ba, 124bc, 124cb, 124cd, 124dc, 124da, and 124ad are reduced, the frame members 121a, 121b, 121c, and 121d extend outwardly to extend the screen extending frame 120, and therefore, a tensile force is exerted on the screen fixed to the extended screen extending frame.

Since the tensile force is exerted even in the state of not using the extending jig, it is possible to keep the screen to be in tension even in the state where the screen is simply fixed to the screen extending frame, and there occurs no sagging in the screen.

Insertion of a solid elastic element such as natural rubber or synthetic rubber or a non-solid spring such as a plate spring or a coil spring into the cut grooves 123a, 123b, 123c, 123d, 124ab, 124ba, 124bc, 124cb, 124cd, 124dc, 124da, and 124ad enables protection of the open ends and supplementation of elasticity.

### Embodiment 11

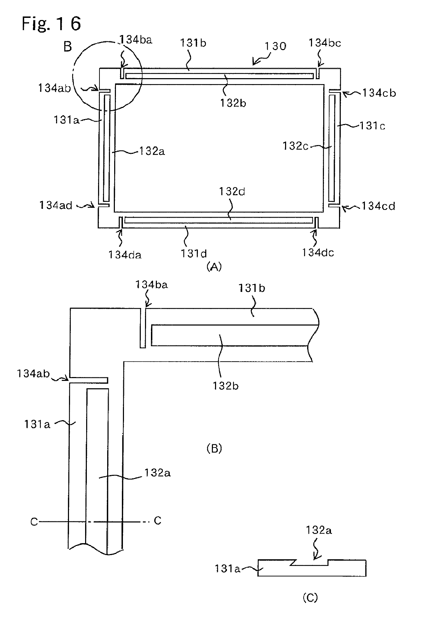

Embodiment 11 is shown in Fig. 16.
Description of the function corresponding to that of Fig. 5 or Fig. 7 is omitted.
In Fig. 16, (A) is an overall view of a screen extending frame 130, (B) is an enlarged exploded view of a portion indicated by a dashed circle B in (A), and (C) is a cross-sectional view of a portion indicated by a dashed line C in (B).

As shown in Fig. 16 (A) of the overall view and Fig. 16 (B) of the enlarged exploded view, the screen extending frame 130 is assembled with four frame members 131a, 131b, 131c, and 131d to be formed in a rectangular shape, and structured by fixedly joined by means of welding, or the like.

On the four frame members 131a, 131b, 131c, and 131d, engagement grooves 132a, 132b, 132c, and 132d with which engagement elements formed in a screen extending jig are engaged each are formed.

There are formed on the frame member 131a a narrow cut groove 134ab that leads to the inner side orthogonally from the outer side at the joint with the frame member 131b and a narrow cut groove 134ad that leads to the inner side orthogonally from the outer side at the joint thereof with the frame member 131d; on the frame member 131b a narrow cut groove 134ba that leads to the inner side orthogonally from the outer side at the joint with the frame member 131a and a narrow cut groove 134bc that leads to the inner side orthogonally from the outer side at the joint thereof with the frame member 131c; on the frame member 131c a narrow cut groove 134cb that leads to the inner side orthogonally from the outer side at the joint with the frame member 131b and a narrow cut groove 134cd that leads to the inner side orthogonally from the outer side at the joint thereof with the frame member 131d; and on the frame member 131d a narrow cut groove 134dc that leads to the inner side orthogonally from the outer side at the joint with the frame member 131c and a narrow cut groove 134da that leads to the inner side orthogonally from the outer side at the joint thereof with the frame member 131a.

All of the four frame members 131a, 131b, 131c, and 131d have the same cross-sectional shape, the engagement groove 132a with which an engagement element of the screen extending jig is engaged is formed on one face of the frame member 131a as shown by the cross-section in Fig. 16 (C), and the opposite face is set to be a plane in order to attach the screen thereto.

When the screen is attached to the screen extending frame 130, the engagement elements of the extending jig are engaged with the engagement grooves 132a, 132b, 132c, and 132d, and the extending jig is extended and reduced, the screen extending frame 130 extends and reduces, and accordingly, the tensile force to the screen is adjusted.

When the screen extending frame 130 configured by combining the four frame members 131a, 131b, 131c, and 131d is pressed in the inward direction using a tool such as the screen extending jig, a clamp, a vise, or the like, the open ends of the cut grooves 134ab, 134ba, 134bc, 134cb, 134cd, 134dc, 134da, and 134ad that are formed in the outer side are reduced, and accordingly, the frame members 131a, 131b, 131c, and 131d inwardly bend, causing the screen extending frame 130 to be reduced.

The screen is, then, fixed to the reduced screen extending frame by means of adhesion, or the like.

In the state where fixation of the screen to the reduced screen extending frame is completed, the pressing force to the reduced screen extending frame exerted by the screen extending jig, the clamp, the vice, or the like is released.

As a result of releasing the pressing force to the reduced screen extending frame, the frame members that inwardly bend will all return to the shape of the state not being compressed, and as the open ends of the cut grooves 134ab, 134ba, 134bc, 134cb, 134cd, 134dc, 134da, and 134ad that are formed in the outer side are widely open, the frame members 131a, 131b, 131c, and 131d extend outwardly to extend the screen extending frame 110, and therefore, a tensile force is exerted on the screen attached to the extended screen extending frame.

Since the tensile force is exerted even in the state of not using the extending jig, it is possible to keep the screen to be in tension even in the state where the screen is simply fixed to the screen extending frame, and there occurs no sagging in the screen.

Insertion of a solid elastic element such as natural rubber or synthetic rubber or a non-solid spring such as a plate spring or a coil spring into the cut grooves 1.34ab, 134ba, 134bc, 134cb, 134cd, 134dc, 134da, and 134ad enables protection of the open ends and supplementation of elasticity.

### Embodiment 12

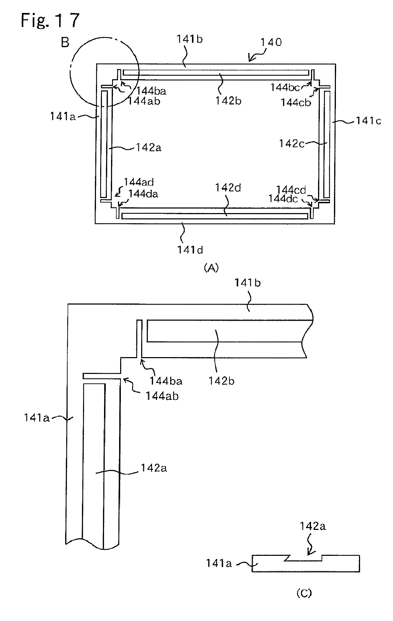

Embodiment 12 is shown in Fig. 17.
Description of the function corresponding to that of Fig. 5 or Fig. 7 is omitted.
In the drawing, (A) is an overall view of a screen extending frame 140, (B) is an enlarged exploded view of a portion indicated by a dashed circle B in (A), and (C) is a cross-sectional view of a portion indicated by a dashed line C in (B).

As shown in Fig. 17 (A) of the overall view and Fig. 17 (B) of the enlarged exploded view, the screen extending frame 140 is assembled with four frame members 141a, 141b, 141c, and 141d to be formed in a rectangular shape, and structured by fixedly joined by means of welding, or the like.

On the four frame members 141a, 141b, 141c, and 141d, engagement grooves 142a, 142b, 142c, and 142d with which engagement elements formed in a screen extending jig are engaged each are formed.

There are formed on the frame member 141a a narrow cut groove 144ab that leads to the outer side orthogonally from the inner side at the joint with the frame member 141b and a narrow cut groove 144ad that leads to the outer side orthogonally from the inner side at the joint thereof with the frame member 141d; on the frame member 141b a narrow cut groove 144ba that leads to the outer side orthogonally from the inner side at the joint with the frame member 141a and a narrow cut groove 144bc that leads to the outer side orthogonally from the inner side at the joint thereof with the frame member 141c; on the frame member 141c a narrow cut groove 144cb that leads to the outer side orthogonally from the inner side at the joint with the frame member 141b and a narrow cut groove 144cd that leads to the outer side orthogonally from the inner side at the joint thereof with the frame member 141d; and on the frame member 141d a narrow cut groove 144dc that leads to the outer side orthogonally from the inner side at the joint with the frame member 141c and a narrow cut groove 144da that leads to the outer side orthogonally from the inner side at the joint thereof with the frame member 141a.

All of the four frame members 141a, 141b, 141c, and 141d have the same cross-sectional shape, the engagement groove 142a with which an engagement element of the screen extending jig is engaged is formed on one face of the frame member 141a as shown by the cross-section in Fig. 17 (C), and the opposite face is set to be a plane in order to attach the screen thereto.

When the screen is attached to the screen extending frame 140, the engagement elements of the extending jig are engaged with the engagement grooves 142a, 142b, 142c, and 142d, and the extending jig is extended and reduced, the screen extending frame 140 extends and reduces, and accordingly, the tensile force to the screen is adjusted.

When the screen extending frame 140 configured by combining the four frame members 141a, 141b, 141c, and 141d is pressed in the inward direction using a tool such as the screen extending jig, a clamp, a vise, or the like, the open ends of the cut grooves 143ab, 143ba, 143bc, 143cb, 143cd, 143dc, 143da, and 143ad that are formed in the inner side are reduced, and accordingly, the frame members 141a, 141b, 141c, and 141d inwardly bend, causing the screen extending frame 140 to be reduced.

The screen is, then, fixed to the reduced screen extending frame by means of adhesion, or the like.

In the state where fixation of the screen to the reduced screen extending frame is completed, the pressing force to the reduced screen extending frame exerted by the screen extending jig, the clamp, the vice, or the like is released.

As a result of releasing the pressing force to the reduced screen extending frame, the frame members that inwardly bend will all return to the shape of the state not being compressed, and as the open ends of the cut grooves 144ab, 144ba, 144bc, 144cb, 144cd, 144dc, 144da, and 144ad that are formed in the inner side are widely open, the frame members 141a, 141b, 141c, and 141d extend outwardly to extend the screen extending frame 140, and therefore, a tensile force is exerted on the screen attached to the extended screen extending frame.

Since the tensile force is exerted even in the state of not using the extending jig, it is possible to keep the screen to be in tension even in the state where the screen is simply fixed to the screen extending frame, and there occurs no sagging in the screen.

Insertion of a solid elastic element such as natural rubber or synthetic rubber or a non-solid spring such as a plate spring or a coil spring into the cut grooves 144ab, 144ba, 144bc, 144cb, 144cd, 144dc, 144da, and 144ad enables protection of the open ends and supplementation of elasticity.

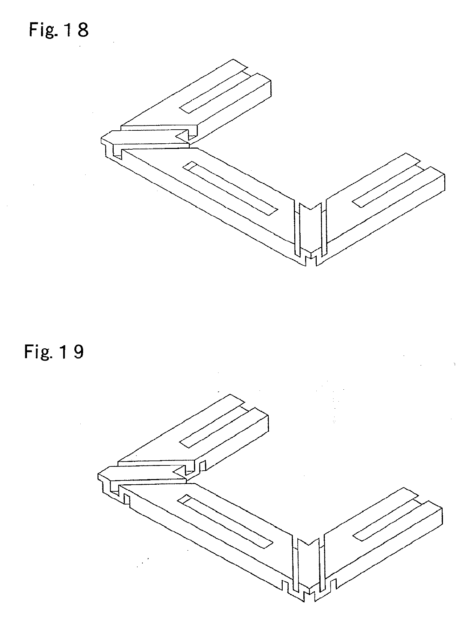

In Embodiments 1 to 12 described using Figs. 4 to 17, the frame members, each of which is solid, provide flexibility by forming cut grooves at the coupling areas of the frame members in the width direction. In Embodiments 13 to 20 to be shown in Figs. 18 to 25, a solid screen extending frame gains flexibility by a way of forming grooves in the both sides of the frame at the coupling areas of the frame members in the thickness direction.

### Embodiment 13

As shown in (a) of Fig. 18 for Embodiment 13, two grooves on one side and one groove on the other side of a joint of solid frame members are formed in the direction connecting the outer angle and the inner angle.
With the grooves, a flexible part that bends in the shape shown by the cross-section in (b) is configured.

### Embodiment 14

As shown in (a) of Fig. 19 for Embodiment 14, two grooves on one side and three grooves on the other side of a joint of solid frame members are formed in the direction connecting the outer angle and the inner angle.
By increasing the number of grooves as above, a flexible part shown by the cross-section in (b) exhibits a greater effect.

### Embodiment 15

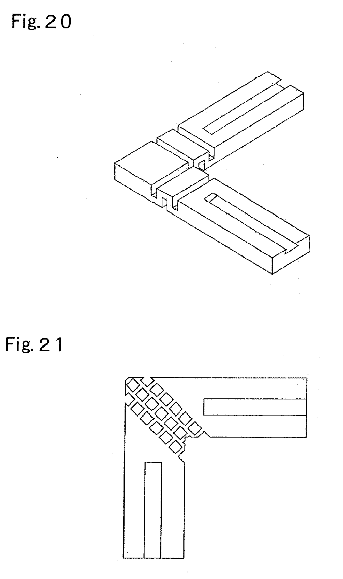

In Embodiment 15 shown in Fig. 20, in the solid frame members two grooves on one side and one groove on the other side are formed respectively at the vicinity of the joint of frame members in the width direction.
A bendable flexible part is configured by these grooves.

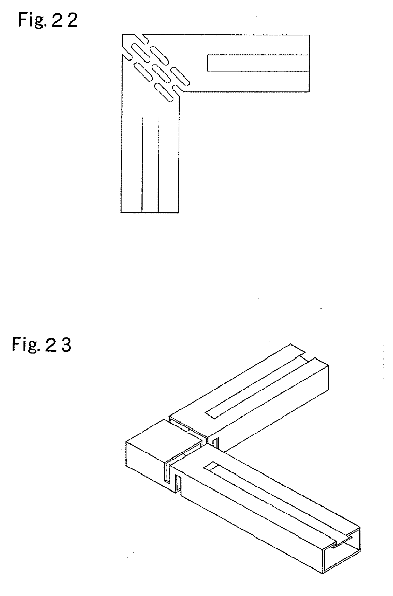

In Embodiments 16 and 17 illustrated in Figs. 21 and 22, a solid screen extending frame gains flexibility at the joint thereof with through holes formed on the joint.

### Embodiment 16

In Embodiment 16 shown in Fig. 21, square-shaped through holes are formed along the direction connecting the inner angle and the outer angle of the joint of solid frame members.

### Embodiment 17

In Embodiment 17 shown in Fig. 22, square-shaped through holes are formed along the direction connecting the inner angle and the outer angle of the joint of solid frame members, and the shape of the through holes are elongated along the arrangement direction.

In Embodiments 18 to 20 illustrated in Figs. 23 to 25, a hollow-bodied screen extending frame gains flexibility at the joint of frame members by cut grooves formed on the joint.

While stress is put on the frame and a screen is attached thereto using a repulsive force against the stress, the sides of the frame bend, and the repulsive power is generated.
The repulsive force is generated strong in the center of the sides of the frame, and weaker as close to the vicinity of couplings of the frame.
The situation is similar also in other configurations, and crinkles may occur around the corners if there is no countermeasure.

### Embodiment 18

In Embodiment 18 shown in Fig. 23, in each of square-shaped hollow frame members one notch is formed on both sides in the vicinity of the joint of frame members in the width direction.
A bendable flexible part is configured with these notches.

### Embodiment 19

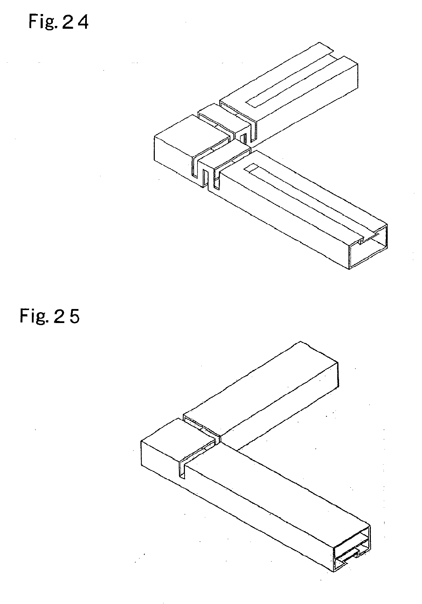

In Embodiment 19 shown in Fig. 24, in each of square-shaped hollow frame members two notches on one side and one notch on the other side are formed respectively in the vicinity of the joint of frame members in the width direction.
A bendable flexible part is configured with such grooves.

### Embodiment 20

In Embodiment 20 shown in Fig. 25, a frame member is constituted by a two-tier hollow body including a hollow body having a plane to which a screen is attached and a hollow body having a plane to which a screen is not attached, and only one tier of the hollow bodies is formed with a notch.

Since the upper half part of the frame is transformed to a rhombus shape by the notch, and a repulsive force to return is generated in the vicinity of the joint, it is possible to apply a tensile force also in the vicinity of the joint and therefore, a screen can be extended in overall uniform. In addition, since the lower half part thereof does not have a notch, the lower half part constitutes a frame with strength.

In this case, it is very effective to make the thickness in the vertical portion of the upper half part of the two-tier hollow body thin and the thickness in the vertical portion of the lower half part of the two-tier hollow body thick.

A notch or a through hole is formed on a wall face in the thickness direction of the frame side in the upper half part of the hollow body in the thickness direction in order to lower the strength of the frame side and to make deformation easy.

By doing this, deformation becomes easy by lowering the strength of the wall face of the upper frame side in the thickness direction, and thus, it is possible to apply a tensile force also in the vicinity of the joint, and overall uniform extending is possible.

Since a notch or a through hole is not formed in the lower half part of the frame side, the lower half part constitutes the frame with strength, that has the same effect as making the thickness in the vertical portion of the upper half part of the two-tier hollow body thin and the thickness in the vertical portion of the lower half part of the two-tier hollow body thick.

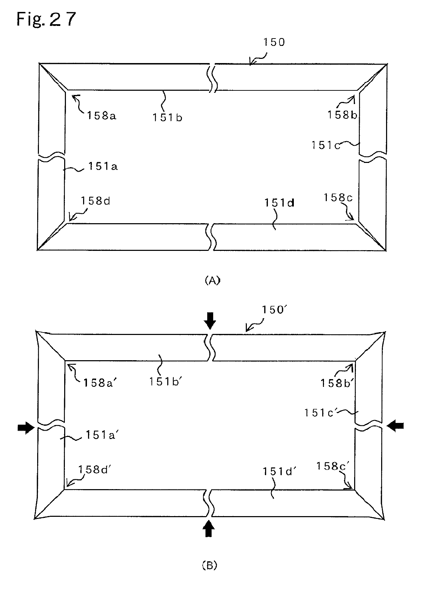

In Embodiment 20 described referring to Figs. 26 and 27, the configuration of end portions of a screen extending frame member allows the screen extending frame to bend using the elasticity of the frame member itself which constitutes the screen extending frame.

### Embodiment 21

Embodiment 21 shown in Fig. 26 is obtained by applying the invention of the present application to the related art shown in Fig. 2. The function of the Embodiment is described referring to Fig. 27.
In Fig. 26, (A) is an overall view of a screen extending frame 150, (B) is an enlarged exploded view of a portion indicated by a dashed circle B in (A), and (C) is a cross-sectional view of a portion indicated by a dashed line C in (B).

The screen extending frame 150 is constituted by two parallel frame members 151a and 151c, two parallel frame members 151b and 151d that are arranged orthogonal to the above frame members, and four corner members 153a, 153b, 153c, and 153d which combine the four frame members. 153a only out of the four corner members is shown in Fig. 26 (B).

Both ends of the frame members 151a and 151b shown as an example of the four frame members 151a, 151b, 151c, and 151d have inclined faces 157a and 157b with an angle of, for example 42° , which is a little smaller than 45 ° with respect to the length direction of the frame members toward the inner side of the screen extending frame 150.
For this reason, both ends of the four frame members 151a, 151b, 151c, and 151d do not contact on a respective complete one plane with each other, and gaps 158a, 158b, 158c, and 158d with an angle of 4° are present in the inner side of the frame, as shown in Fig. 26 (A).
The angle of the gap is not limited to 4 °

All of the four frame members 151a, 151b, 151c, and 151d have the cross-sectional shape shown in the representative example in Fig. 26 (C), and the frame member 151a shown as an example is formed with an insertion hole 155a therein, and an engagement groove 152a with which an engagement element of a screen extending jig engages on one face, and the opposite face is set to be a plane so as to attach a screen.

The corner member 153a is constituted by two corner plates 156a and 156b orthogonal to each other in an L shape, and the corner plates 156a and 156b have a cross-sectional shape each which can comfortably enter and slide in the insertion hole 156a of the frame member 151a and the insertion hole 156b of the frame member 151b respectively.

The corner plate 156a is inserted into the insertion hole 156b in the white arrow direction; the corner plate 156b is inserted into the insertion hole 156b in the white arrow direction, and as in a same way, the four frame members 151a, 151b, 151c, and 151d, and the four corner members 153a, 153b, 153c, and 153d are assembled, and then, the screen extending frame 150 with the gaps 158a, 158b, 158c, and 158d is configured.

The screen is attached to the screen extending frame 150, engagement elements of the extending jig are engaged with engagement grooves 152a, 152b, 152c, and 152d, and the corner plates inserted in the insertion holes slide in the insertion holes when the extending jig extends and reduces, and accordingly, the screen extending frame 150 extends and reduces, whereby a tensile force is exerted on the screen.

Using Fig. 27, the function of the screen extending frame shown in Fig. 25 is described.
In the drawing, Fig. 27 (A) shows the state of the screen extending frame before the screen is attached thereto, and Fig. 27 (B) shows the state of the screen extending frame immediately before the screen is attached thereto.

Since the screen extending frame 150 shown in Fig. 27 (A) is the same as one described based on Fig. 3, description thereof is not provided here.

As shown in Fig. 27 (B), the screen extending frame 150 configured by assembling the four frame members 151a, 151b, 151c, and 151d and the four corner members 153a, 153b, 153c, and 153d not shown in the drawing is pressed in the black arrow directions using a tool such as a screen extending jig, a clamp, a vise, or the like not shown in the drawing.

As a result, the outer end of each frame members is deformed, the gap 158a between the frame members 151a and 151b, the gap 158b between the frame members 151b and 151c, the gap 158c between the frame members 151c and 151d, and the gap 158d between the frame members 151d and 151a are reduced to form gaps 158a' , 158b', 158c' and 158d' , or disappear, and each of the frame members are inwardly reduced as shown by 151a' , 151b', 151c', and 151d'.

As each of the gaps is thus, reduced or disappears, in the state of, as a result, the shape of a screen extending frame 150' that inwardly bends, the screen is fixed to the screen extending frame 150' by means of adhesion, or the like.

In the state where fixation of the screen to the screen extending frame 150' is completed, the pressing force to the screen extending frame 150' exerted by the screen extending jig, the clamp, the vice, or the like is released.

The frame members 151a', 151b'. 151c' , and 151d' released from the pressing force will return to the state of not bending with their own elasticity.
As a result, a tensile force is exerted on the fixed screen.

In addition, insertion of a solid elastic clement such as natural rubber, synthetic rubber, or the like, or a plate or a linear spring, or the like shown in Embodiment 2 of Fig. 6 into the gaps 158a, 158b, 158c, and 158d also can further improve performance of exerting a tensile force on the screen.

Since the tensile force is exerted even in the state of not using the extending jig, it is possible to keep the screen to be in tension even in the state where the screen is simply fixed to the screen extending frame, and printing is possible without using the screen extending jig with no sagging in the screen.

### Embodiment 22

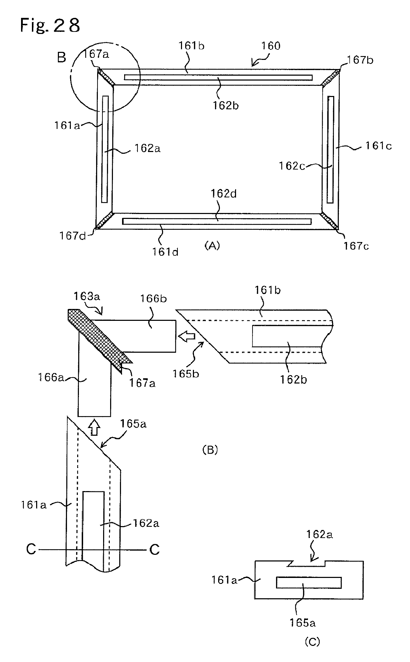

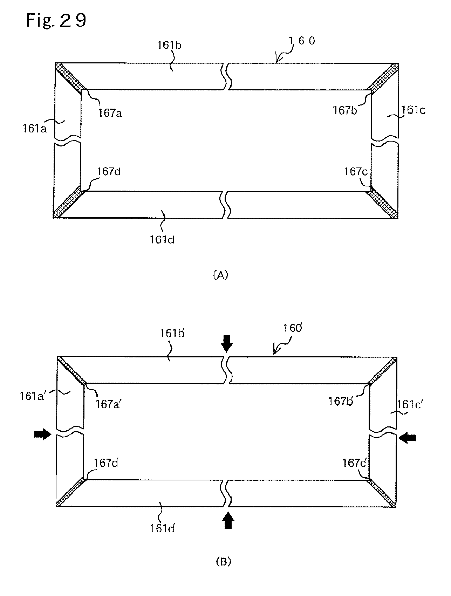

Embodiment 22 shown in Fig. 28 is obtained by applying the invention of the present application to the related art shown in Fig. 3 similarly to Embodiment 21. Its function is described referring to Fig. 29.
In Fig. 28, (A) is an overall view of a screen extending frame 160, (B) is an enlarged exploded view of a portion indicated by a dashed circle B in (A), and (C) is a cross-sectional view of a portion indicated by a dashed line C in (B).

The screen extending frame 160 is constituted by two parallel frame members 161a and 161c, two parallel frame members 161b and 161d that are arranged orthogonal to the above frame members, and four corner members 163a, 163b, 163c, and 163d which combine the four frame members.
Only 163a out of the four corner members is shown in Fig. 28 (B).

On the four frame members 161a, 161b, 161c, and 161d, engagement grooves 162a, 162b, 162c, and 162d with which engagement elements formed on a screen extending jig are engaged each are formed.

All of the four frame members 161a, 161b, 161c, and 161d have the same cross-sectional shape. On the frame member 161a shown as a representative example in Fig. 28 (B), an insertion hole 46a is formed inside thereof, the engagement groove 162a with which an engagement element of a screen extending jig engages is formed on one face, and the opposite face is set to be a plane so as to attach a screen.
Both ends of the four frame members 161a, 161b, 161c, and 161d have inclined faces with an angle of, for example 45? with respect to the length direction, which is inclined to the inner side of the screen extending frame 160.

All of the four corner members 163a, 163b, 163c, and 163d have the same shape, and 163a shown as a representative example in Fig. 28 (B) is constituted by two corner plates 166a and 166b orthogonal to each other in an L shape, and the corner plates 166a and 166b have a cross-sectional shape each that enables comfortable insertion and sliding in the insertion hole 165a of the frame member 161a and the insertion hole 165b of the frame member 161b respectively.

The screen extending frame 160 is configured in such a way that the corner plate 166a is inserted into the insertion hole 165b of the frame member 161a in the arrow direction, the corner plate 166b is inserted into the insertion hole 45b of the frame member 161b in the arrow direction, and thereby, the four frame members 161a, 161b, 161c, and 161d, and the four corner members 163a, 163b, 163c, and 163d are assembled.

The screen is attached to the screen extending frame 160, the engagement elements of the extending jig are engaged with the engagement grooves 162a, 162b, 162c, and 162d, and when the extending jig is extended and reduced, the corner plates inserted in the insertion holes slide in the insertion holes and accordingly, the screen extending frame 160 extends and reduces, whereby a tensile force is exerted on the screen.

As shown in Fig. 28 (B), an elastic element 167a is disposed at the location where the corner plates 166a and 166b of the corner member 163a orthogonally contact with each other.
Fig. 28 (A) shows other elastic elements 168b, 168c, and 168d in addition to the elastic element 167a.

For the elastic element, a solid elastic element such as rubber, or a hollow elastic element such as a plate spring or a coil spring can be used.

In addition, it is easy to provide the elastic element 167a by being divided into two, one of which is provided from the corner plate 166a and the other one of which is provided from the corner plate 166b.

The function of the screen extending frame 160 is described referring to Fig. 29.
In the drawing, (A) shows the state of the screen extending frame before the screen is attached thereto, and (B) shows the state of the screen extending frame immediately before the screen is attached thereto.

Since the screen extending frame 160 shown in Fig. 29 (A) is the same as one described based on Fig. 3, description thereof is not provided here.

As shown in Fig. 29 (B), the screen extending frame 160 configured by assembling the four frame members 161a, 161b, 161c, and 161d and the four corner members 163a, 163b, 163c, and 163d not shown in the drawing is pressed in the black arrow directions using a tool such as the screen extending jig, a clamp, a vise, or the like not shown in the drawing.

Then, an elastic element 167a' provided in the corner member 163a, an elastic element 167b' provided in the corner member 163b, an elastic element 167c ' provided in the corner member 163c, and an elastic element 167d' provided in the corner member 163d are all put in a compressed state.

As a result of each elastic element compressed as above, the screen extending frame 160 becomes a reduced screen extending frame 160'. In this state, the screen is fixed to the screen extending frame 160' by means of adhesion, or the like.

In the state where fixation of the screen to the reduced screen extending frame 160' is completed, the pressing force to the reduced screen extending frame 160' exerted by the screen extending jig, the clamp, the vice, or the like is released.

The elastic elements 167a', 167b', 167c', and 167d' released from the pressing force will all return to the state of not compressed, thereby the screen extending frame 160' extends, and therefore, a tensile force is exerted on the screen attached to the screen extending frame 160' thus extended.

Since the tensile force is exerted even in the state of not using the extending jig, it is possible to keep the screen to be in tension even in the state where the screen is simply fixed to the screen extending frame, and printing is possible without using the screen extending jig with no sagging in the screen.

### Embodiment 23

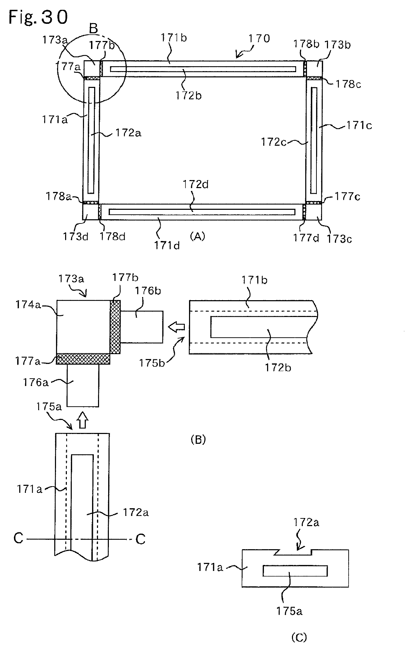

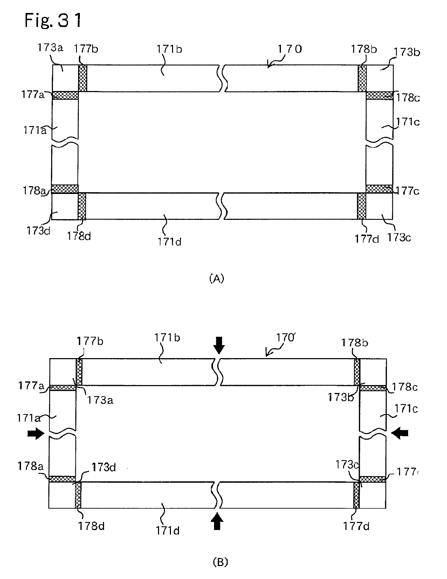

Embodiment 23 shown in Fig. 30 is obtained by applying the invention of the present application to the related art shown in Fig. 3. Its function of the embodiment is described referring to Fig. 31. In the Fig. 30, (A) is an overall view of a screen extending frame 170, (B) is an enlarged exploded view of a portion indicated by a dashed circle B in (A), and (C) is a cross-sectional view of a portion indicated by a dashed line C in (B).

The screen extending frame 170 is constituted by two parallel frame members 171a and 171c, two parallel frame members 171b and 171d that are arranged orthogonal to the above frame members, and four corner members 173a, 173b, 173c, and 173d which combine the four frame members.

On the four frame members 171a, 171b, 171c, and 171d, engagement grooves 172a, 172b, 172c, and 172d with which engagement elements formed on a screen extending jig are engaged each are formed.

All of the four frame members 171a, 171b, 171c, and 171d have the same cross-sectional shape. On the frame member 171a shown as a representative example in Fig. 30 (B), an insertion hole 55a is formed inside thereof, the engagement groove 172a with which an engagement element of a screen extending jig engages is formed on one face, and the opposite face is set to be a plane so as to attach a screen.
In addition, both ends of the four frame members 171a, 171b, 171c, and 171d have faces with an angle of 90? with respect to the length direction.

All of the four corner members 173a, 173b, 173c, and 173d have the same shape. The corner member 173a shown as a representative example in Fig. 30 (B) includes a main body 174a having a square-shape on its upper surface, provided with two corner plates 176a and 176b orthogonal to each other. The corner plates 176a and 176b have a cross-sectional shape that enables comfortable insertion and sliding in the insertion hole 175a of the frame member 171a and the insertion hole 175b of the frame member 171b respectively.

The screen extending frame 170 is configured in such a way that the corner plate 176a is inserted into the insertion hole 175b of the frame member 171a in the arrow direction, the corner plate 176b is inserted into the insertion hole 175b of the frame member 171b in the arrow direction, and thereby, the four frame members 171a, 171b, 171c, and 171d, and the four corner members 173a, 173b, 173c, and 173d are assembled.

The screen is attached to the screen extending frame 170, the engagement elements of the extending jig are engaged with the engagement grooves 172a, 172b, 172c, and 172d, and when the extending jig is extended and reduced, the corner plates inserted in the insertion holes slide in the insertion holes and accordingly, the screen extending frame 170 extends and reduces, whereby a tensile force exerted on the screen is adjusted.

As shown in Fig. 30 (A) and Fig. 30 (B), an elastic element 177a is provided in the corner plate 176a at the location where the corner member 173a contacts the frame member 171a, and an elastic element 177b is provided in the corner plate 176b at the location where the corner member 173a contacts the frame member 171b.

In the same manner, there are provided with elastic elements 178b and 178c in each of two corner plates of the corner member 173b; elastic elements 177c and 177d in each of two corner plates of the corner member 173c; and elastic elements 178d and 178a in each of two corner plates of the corner member 173d.
For the provided elastic element, a solid elastic element such as natural rubber or synthetic rubber, or a hollow elastic element such as a plate spring or a coil spring can be used.

The function of the screen extending frame 170 is described referring to Fig. 30.
In the drawing, (A) shows the state of the screen extending frame before the screen is attached thereto, and (B) shows the state of the screen extending frame immediately before the screen is attached thereto.

Since the screen extending frame 170 shown in Fig. 31 (A) is the same as one described based on Fig. 8, description thereof is not provided here.

As shown in Fig. 31 (B), the screen extending frame 170 configured by assembling the four frame members 171a, 171b, 171c, and 171d and the four corner members 173a, 173b, 173c, and 173d is pressed in the black arrow directions using a tool such as a screen extending jig, a clamp, a vise, or the like not shown in the drawing.

Then, all of elastic elements 177a', 177b', 178b', 178c', 177c', 177d' , 178d', and 178a' are put in a compressed state, and as a result, the screen extending frame 170 is reduced to a reduced screen extending frame 170' constituted by curved frame members 171a', 171b', 171c' , and 171d' .

The screen is, then, fixed to the reduced screen extending frame 170' by means of adhesion, or the like.

In the state where fixation of the screen to the reduced screen extending frame 170' is completed, the pressing force to the reduced screen extending frame 170' exerted by the screen extending jig, the clamp, the vice, or the like is released.

As a result of releasing the pressing force to the reduced screen extending frame 170' , all of the elastic elements 177a' , 177b' , 178b' , 178c', 177c' , 177d' , 178d' , and 178a' will return to the state of not compressed, the screen extending frame 170' extends, and therefore, a tensile force is exerted on the screen attached to the screen extending frame thus extended.

Since the tensile force is exerted even in the state of not using the extending jig, it is possible to keep the screen to be in tension even in the state where the screen is simply fixed in the screen extending frame, and printing is possible without using the screen extending jig with no sagging in the screen.

### Industrial Applicability

As understood from the above description, according to the screen extending frame of the present invention, since a tensile force is exerted on the screen thus attached thereto, even in the state of not using an extending jig, it is possible to keep the screen to be in tension even when the screen is simply fixed in the screen extending frame, and printing is possible without using the screen extending jig with no sagging in the screen.
Therefore, it is possible to safely store and transport the screen even after being taken out from a screen extending jig that is heavy, bulky, and expensive, with regard to storage and transportation. That is useful for managing the screen to be used in screen printing.

In addition, installation of a mechanism for mounting a screen extending frame on a screen printing machine and a mechanism for expanding and reducing the mounted screen extending frame makes an overall configuration of the printing machine simple.

### Reference Numerals

1 screen extending jig
2 screen extending frame
3 screen
4, 12a ∼ 12d, 22a ∼ 22d, 32a ∼ 32d, 42a ∼ 42d, 52a ∼ 52d, 62a ∼ 62d, 72a ∼ 72d, 82a ∼ 82d, 92a ∼ 92d, 102a ∼ 102d, 112a ∼ 1 1 2 d, 122 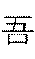 ∼ 122d, 132a ∼ 132d engaging grooves
5 engaging element
10, 20, 30, 40, 50, 60, 70, 80, 90, 100, 11-0, 120, 130, 140, 150, 160, 170 screen extending frame
11a ∼ 11d, 21a ∼ 21d, 31a ∼ 31d, 41a ∼ 41d, 51a ∼ 51d, 61a ∼ 61d, 71a ∼ 71d, 81a ∼ 81d, 91a ∼ 91d, 101a ∼ 101d, 111a ∼ 111d, 121a ∼ 121d, 131a ∼ 131d, 141a ∼ 141d, 151a ∼ 151d, 161a ∼ 161d, 171a ∼ 171d frame members
13a, 23a ∼ 23d, 163a, 173a ∼ 173d, 43a corner member
167a ∼ 167d, 177a ∼ 177d, 178a ∼ 178d elastic element
33a ∼ 33d, 43a ∼ 43d, 53a ∼ 53d, 63a ∼ 63d, 73a ∼ 73d, 83a ∼ 83d, 93a ∼ 93d, 103a ∼ 103d, 123a ∼ 123d cutting groove

## Claims

1. A screen extending frame in a rectangular shape, comprising:
four frame members having the square-shape cross-section, being used in such a way that a screen is attached to one face thereof, and the other face thereof is mounted on a screen extending jig having an extending and reducing function,
wherein couplings of said four frame members have flexibility and elasticity.

2. The screen extending frame according to claim 1,
wherein said four frame members connect in said couplings, and the couplings have flexibility and elasticity.

3. The screen extending frame according to claim 2,
wherein said four frame members are solid bodies.

4. The screen extending frame according to claim 3,
wherein cut grooves are formed in the width direction of said couplings.

5. The screen extending frame according to claim 3,
wherein cut grooves are formed in the direction connecting the outer angle and the inner angle each of said couplings.

6. The screen extending frame according to claim 3,
wherein grooves are formed on both faces of said couplings in the thickness direction.

7. The screen extending frame according to claim 7,
wherein said grooves in the thickness direction are formed in the width direction of said frame members.

8. The screen extending frame according to claim 6,
wherein said grooves in the thickness direction are formed in the direction connecting the outer angle and the inner angle each of said couplings.

9. The screen extending frame according to claim 3,
wherein through holes are formed in the thickness direction of said couplings.

10. The screen extending frame according to claim 9,
wherein said through holes are arranged in the direction connecting the outer angle and the inner angle each of said couplings.

11. The screen extending frame according to claim 9,
wherein said through holes are arranged in the width direction of said frame members.

12. The screen extending frame according to claim 1,
wherein said four frame members are hollow bodies.

13. The screen extending frame according to claim 13,
wherein notch portions are formed in the thickness direction of said couplings.

14. The screen extending frame according to claim 13,
wherein said notch portions are formed in the direction orthogonal to the longitudinal direction of said frame members.

15. The screen extending frame according to claim 13,
wherein said notch portions are formed in the direction connecting the outer angle and the inner angle each of said couplings.

16. The screen extending frame according to claim 12,
wherein said notch portions are formed in the width direction of said frame members.

17. The screen extending frame according to claim 16,
wherein said notch portions are formed in the direction connecting the outer angle and the inner angle each of said couplings.

18. The screen extending frame according to claim 12,
wherein through holes are formed in said couplings toward the thickness direction of said frame members.

19. The screen extending frame according to claim 18,
wherein said through holes are arranged in the direction connecting the outer angle and the inner angle each of said couplings.

20. The screen extending frame according to claim 18,
wherein said through holes are arranged in the direction orthogonal to the longitudinal direction of said frame members.

21. The screen extending frame according to claim 18,
wherein said through holes are arranged in the width direction of said frame members.

22. The screen extending frame according to claim 1,
wherein said four frame members are two-tier hollow bodies including respectively a hollow body having a plane onto which said screen is attached and a hollow body having a plane onto which said screen is not attached.

23. The screen extending frame according to claim 22,
wherein notch portions are formed in the thickness direction of the couplings of said hollow bodies each having the plane onto which said screen is attached.

24. The screen extending frame according to claim 23,
wherein said notch portions are formed in the width direction of said couplings.

25. The screen extending frame according to claim 22,
wherein notch portions are formed on a wall face in the thickness direction of the frame side of the upper half hollow body in said two-tier hollow body.

26. The screen extending frame according to claim 22,
wherein through holes are formed on a wall face in the thickness direction of the frame side of the upper half hollow body in said two-tier hollow body.

27. The screen extending frame according to claim 1,
wherein said four frame members are individual units, adjacent frame members are joined by a corner member respectively, and couplings of said four frame members and said four corner members have flexibility and elasticity.

28. The screen extending frame according to claim 27,
wherein end faces of connecting portions to which said four frame members are adjacent are faces inclined in the longitudinal direction of said four frame members, and gaps are formed between respective inclined faces.

29. The screen extending frame according to claim 27,
wherein end faces of connecting portions to which said four frame members are adjacent are faces inclined in the longitudinal direction of said four frame members, and elastic elements are provided between respective inclined faces.

30. The screen extending frame according to claim 29,
wherein said elastic element is made of natural rubber or synthetic rubber.

31. The screen extending frame according to claim 29,
wherein said elastic element is a coil spring.

32. The screen extending frame according to claim 29,
wherein said elastic element is a leaf spring.

33. The screen extending frame according to claim 27,
wherein end faces of connecting portions to which said four frame members are adjacent are faces orthogonal to the longitudinal direction of said four frame members, said corner members are rectangular parallelepiped shape, and elastic elements are provided respectively between the orthogonal faces of said frame members and said corner members.

34. The screen extending frame according to claim 33,
wherein said elastic element is made of natural rubber or synthetic rubber.

35. The screen extending frame according to claim 33,
wherein said elastic element is a coil spring.

36. The screen extending frame according to claim 33,
wherein said elastic element is a leaf spring.

37. A screen printing apparatus, having:
a mechanism for mounting a screen extending frame; and
a mechanism for extending and reducing the mounted screen extending frame.
